(19) Europäisches Patentamt
European Patent Office
Office européen des brevets

(11) **EP 4 716 086 A1**

(12) **EUROPEAN PATENT APPLICATION**
published in accordance with Art. 153(4) EPC

(43) Date of publication:
**25.03.2026 Bulletin 2026/13**

(51) International Patent Classification (IPC):
**H02M 7/48** (2007.01)   **H02M 1/08** (2006.01)

(21) Application number: **24806934.6**

(52) Cooperative Patent Classification (CPC):
**H02M 1/08; H02M 7/48**

(22) Date of filing: **15.04.2024**

(86) International application number:
**PCT/JP2024/015024**

(87) International publication number:
**WO 2024/236980 (21.11.2024 Gazette 2024/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **16.05.2023 JP 2023081077**

(71) Applicant: **Panasonic Intellectual Property
Management Co., Ltd.
Kadoma-shi, Osaka 571-0057 (JP)**

(72) Inventors:
• **KABASHIMA, Takamune
Kadoma-shi, Osaka 571-0057 (JP)**
• **ARAI, Yasuhiro
Kadoma-shi, Osaka 571-0057 (JP)**
• **SUZUKI, Asamira
Kadoma-shi, Osaka 571-0057 (JP)**
• **NAKAMURA, Hirokazu
Kadoma-shi, Osaka 571-0057 (JP)**
• **HEGDE, Anantha
Kadoma-shi, Osaka 571-0057 (JP)**

(74) Representative: **Novagraaf International SA
Chemin de l'Echo 3
1213 Onex, Geneva (CH)**

(54) **ELECTRIC POWER CONVERSION APPARATUS**

(57)     The problem is to reduce the chances of causing a voltage drop in a bootstrap circuit. A control unit (60) has a first control mode, a second control mode, and a third control mode. In the first control mode, the control unit (60) controls a first switching element (Q1), a second switching element (Q2), a third switching element (Q3), and a fourth switching element (Q4) so that the first, second, third, and fourth switching elements (Q1, Q2, Q3, Q4) are ON, ON, OFF, and OFF, respectively. In the second control mode, the control unit (60) controls the first, second, third, and fourth switching elements (Q1-Q4) so that the first, second, third, and fourth switching elements (Q1-Q4) are OFF, ON, ON, and OFF, respectively. In the third control mode, the control unit (60) controls the first, second, third, and fourth switching elements (Q1-Q4) so that the first, second, third, and fourth switching elements (Q1-Q4) are OFF, ON, OFF, and ON, respectively When the polarity of a current flowing through an output terminal (41) is positive, the control unit (60) makes a transition to the first control mode via the second control mode immediately after having gone through the third control mode.

FIG. 1

**Description**

**Technical Field**

The present disclosure generally relates to a power converter, and more particularly relates to a power converter including a bootstrap circuit.

**Background Art**

Patent Literature 1 discloses a switching element driver circuit for a three-level neutral-point-clamping inverter.

The neutral-point-clamping inverter disclosed in Patent Literature 1 includes: a series circuit (switching circuit) of a first switching element, a second switching element, a third switching element, and a fourth switching element; a first clamping diode (first diode); a second clamping diode (second diode); and a series circuit (DC power supply unit) of two smoothing capacitors for smoothing a DC voltage and generating a neutral point potential thereof.

The switching element driver circuit includes: a first gate driver circuit (first gate driver) for driving the first switching element; a second gate driver circuit (second gate driver) for driving the second switching element; a third gate driver circuit (third gate driver) for driving the third switching element; and a fourth gate driver circuit (fourth gate driver) for driving the fourth switching element. A switching signal is supplied from a control circuit (control unit) to each of the first gate driver circuit, the second gate driver circuit, the third gate driver circuit, and the fourth gate driver circuit.

The switching element driver circuit further includes a gate power supply (power supply unit). A negative-side terminal of the gate power supply is connected, along with a negative-side terminal of the fourth gate driver circuit, to a negative power line. On the other hand, a positive-side terminal of the gate power supply is connected, along with a positive-side terminal of the fourth gate driver circuit, to a positive-side terminal of the third gate driver circuit via a forward biased diode.

A negative-side terminal of the third gate driver circuit is connected to a common connection node of the third switching element and the fourth switching element. A capacitor is connected to the third gate driver circuit in parallel.

In a power converter including the three-level neutral-point-clamping inverter and the switching element driver circuit as disclosed in Patent Literature 1, a bootstrap circuit including a capacitor and a diode which is connected to the third gate driver circuit in parallel sometimes causes a voltage drop, which may be a problem with such a power converter.

**Citation List**

**Patent Literature**

Patent Literature 1: JP 2018-133876 A

**Summary of Invention**

An object of the present disclosure is to provide a power converter which may reduce the chances of causing a voltage drop in a bootstrap circuit.

A power converter according to an aspect of the present disclosure includes a DC power supply unit, a switching circuit, a first diode, a second diode, an output terminal, a first gate driver, a second gate driver, a third gate driver, a fourth gate driver, a bootstrap circuit, a power supply unit, and a control unit. The DC power supply unit includes a positive electrode, a negative electrode, and an intermediate potential node. The switching circuit includes a first switching element, a second switching element, a third switching element, and a fourth switching element. In the switching circuit, the first switching element, the second switching element, the third switching element, and the fourth switching element are connected in series between the positive electrode and the negative electrode to be arranged in this order from the positive electrode toward the negative electrode. The first diode has a cathode connected to a first connection node between the first switching element and the second switching element and an anode connected to the intermediate potential node. The second diode has an anode connected to a second connection node between the third switching element and the fourth switching element and a cathode connected to the intermediate potential node. The output terminal is connected to a third connection node between the second switching element and the third switching element and is to be connected to an AC load. The first gate driver drives the first switching element. The second gate driver drives the second switching element. The third gate driver drives the third switching element. The fourth gate driver drives the fourth switching element. The bootstrap circuit supplies voltage to the third gate driver. The power supply unit supplies voltage to the bootstrap circuit and the fourth gate driver. The control unit controls the first gate driver, the second gate driver, the third gate driver, and the fourth gate driver. The control unit has a first control mode, a second control mode, and a third control mode. In the first control mode, the control unit controls the first switching element, the second switching element, the third switching element, and the fourth switching element such that the first switching element is ON, the second switching element is ON, the third switching element is OFF, and the fourth switching element is OFF. In the second control mode, the control unit controls the first switching element, the second switching element, the third switching element, and the fourth switching element such that the first switching element is OFF, the second switching element is ON, the third switching element is ON, and the fourth switching element is OFF. In the third control mode, the control unit controls the first switching element, the second switching element, the third switching element, and the fourth switching element such that the first switching element is OFF, the second switching element is ON, the third switching element is OFF, and the fourth switching element is ON. When the polarity of a current flowing through the output terminal is positive, the control unit makes a transition to the first control mode via the second control mode immediately after having gone through the third control mode.

**Brief Description of Drawings**

[FIG. 1] FIG. 1 is a circuit diagram of a system including a power converter according to an exemplary embodiment;
[FIG. 2] FIG. 2 illustrates a current path in a situation where a switching circuit of the power converter is in a first switching state (i.e., when its control unit is operating in a first control mode);
[FIG. 3] FIG. 3 illustrates a discharging path and charging path in the situation where the switching circuit of the power converter is in the first switching state;
[FIG. 4] FIG. 4 illustrates a current path in a situation where the switching circuit of the power converter is in a second switching state;
[FIG. 5] FIG. 5 illustrates a discharging path and charging path in the situation where the switching circuit of the power converter is in the second switching state;
[FIG. 6] FIG. 6 illustrates a current path in a situation where the switching circuit of the power converter is in a third switching state;
[FIG. 7] FIG. 7 illustrates a discharging path and charging path in the situation where the switching circuit of the power converter is in the third switching state;
[FIG. 8] FIG. 8 illustrates a current path in a situation where the switching circuit of the power converter is in a fourth switching state;
[FIG. 9] FIG. 9 illustrates a discharging path and charging path in the situation where the switching circuit of the power converter is in the fourth switching state;
[FIG. 10] FIG. 10 is a waveform diagram of an output current of the power converter;
[FIG. 11] FIG. 11 illustrates how the power converter operates;
[FIG. 12] FIG. 12 shows operating waveforms of the power converter;
[FIG. 13] FIG. 13 shows operating waveforms of the power converter;
[FIG. 14] FIG. 14 shows operating waveforms of the power converter;
[FIG. 15] FIG. 15 shows voltage command values for respective phases in the power converter;
[FIG. 16] FIG. 16 illustrates a group of voltage vectors with respect to the power converter;
[FIG. 17] FIG. 17 illustrates the group of voltage vectors more specifically with respect to the power converter;
[FIG. 18] FIG. 18 is a vector diagram illustrating how a control unit operates in the power converter; and
[FIG. 19] FIG. 19 is a circuit diagram illustrating a system including a power converter according to a variation.

**Description of Embodiments**

(Embodiment)

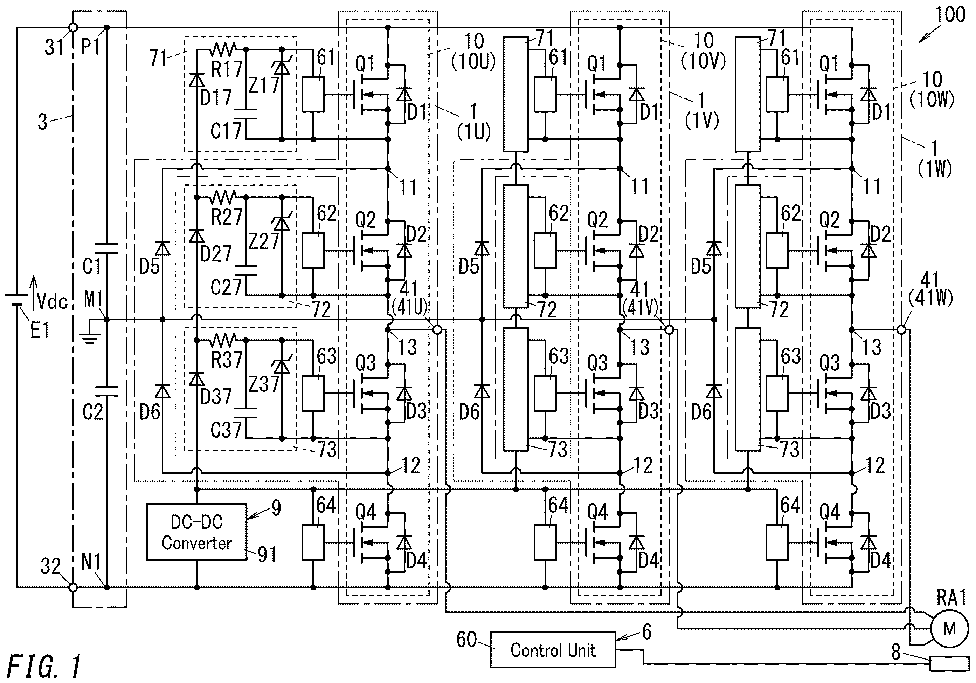

A power converter 100 according to an exemplary embodiment will now be described with reference to FIGS. 1-18.

(1) Overview

The power converter 100 may include, for example, a DC power supply unit 3, a plurality of (e.g., three) inverter circuits 1, and a controller 6 as shown in FIG. 1. The DC power supply unit 3 includes a positive electrode P1, a negative electrode N1, and an intermediate potential node M1. The plurality of inverter circuits 1 are connected between the positive electrode P1 and negative electrode N1 of the DC power supply unit 3. The controller 6 controls the plurality of inverter circuits 1. As used herein, the "intermediate potential node M1" refers to a node where the potential is intermediate between a potential at the positive electrode P1 of the DC power supply unit 3 and a potential at the negative electrode N1 thereof.

The power converter 100 is a diode-clamping three-level three-phase inverter. In the power converter 100, each of the plurality of inverter circuits 1 has an output terminal 41. In the power converter 100, an AC load RA1 is connected to the plurality of output terminals 41.

The AC load RA1 may be, for example, a three-phase motor. In the power converter 100, one of the plurality of inverter circuits 1 is an inverter circuit 1U for outputting a U-phase voltage, another one of the plurality of inverter circuits 1 is an inverter circuit 1V for outputting a V-phase voltage, and the other one of the plurality of inverter circuits 1 is an inverter circuit 1W for outputting a W-phase voltage.

Each of the plurality of inverter circuits 1 includes a switching circuit 10, a diode D1, a diode D2, a diode D3, and a diode D4. Each of the plurality of inverter circuits 1 further includes a diode (first diode) D5 (hereinafter referred to as a "first diode D5") and a diode D6 (hereinafter referred to as a "second diode D6"). In the power converter 100, a potential at the intermediate potential node M1 is clamped by the first diode D5 and the second diode D6 of each inverter circuit 1.

Each switching circuit 10 includes a first switching element Q1, a second switching element Q2, a third switching element Q3, and a fourth switching element Q4. In each switching circuit 10, the first switching element Q1, the second switching element Q2, the third switching element Q3, and the fourth switching element Q4 are connected in series to be arranged in this order from the positive electrode P1 toward the negative electrode N1 of the DC power supply unit 3.

In each inverter circuit 1, the diode D1 is connected to the first switching element Q1 in anti-parallel. The diode D2 is connected to the second switching element Q2 in anti-parallel. The diode D3 is connected to the third switching element Q3 in anti-parallel. The diode D4 is connected to the fourth switching element Q4 in anti-parallel. The first diode D5 has a cathode connected to a first connection node 11 between the first switching element Q1 and the second switching element Q2 and an anode connected to the intermediate potential node M1. The second diode D6 has an anode connected to a second connection node 12 between the third switching element Q3 and the fourth switching element Q4 and a cathode connected to the intermediate potential node M1.

The controller 6 includes a plurality of (e.g., three) first gate drivers 61, a plurality of (e.g., three) second gate drivers 62, a plurality of (e.g., three) third gate drivers 63, and a plurality of (e.g., three) fourth gate drivers 64. In addition, the controller 6 further includes a plurality of (e.g., three) first bootstrap circuits 71, a plurality of (e.g., three) second bootstrap circuits 72, a plurality of (e.g., three) third bootstrap circuits 73, a power supply unit 9, and a control unit 60.

Each of the plurality of first gate drivers 61 drives the first switching element Q1 of a corresponding one of the plurality of inverter circuits 1. Each of the plurality of second gate drivers 62 drives the second switching element Q2 of a corresponding one of the plurality of inverter circuits 1. Each of the plurality of third gate drivers 63 drives the third switching element Q3 of a corresponding one of the plurality of inverter circuits 1. Each of the plurality of fourth gate drivers 64 drives the fourth switching element Q4 of a corresponding one of the plurality of inverter circuits 1.

The plurality of first bootstrap circuits 71 are provided one to one for the plurality of first gate drivers 61. Each of the plurality of first bootstrap circuits 71 supplies voltage to a corresponding one of the plurality of first gate drivers 61. The plurality of second bootstrap circuits 72 are provided one to one for the plurality of second gate drivers 62. Each of the plurality of second bootstrap circuits 72 supplies voltage to a corresponding one of the plurality of second gate drivers 62. The plurality of third bootstrap circuits 73 are provided one to one for the plurality of third gate drivers 63. Each of the plurality of third bootstrap circuits 73 supplies voltage to a corresponding one of the plurality of third gate drivers 63. The power supply unit 9 supplies voltage to the plurality of fourth gate drivers 64.

The control unit 60 controls the plurality of first gate drivers 61, the plurality of second gate drivers 62, the plurality of third gate drivers 63, and the plurality of fourth gate drivers 64.

(2) Details of power converter

The DC power supply unit 3 includes a first capacitor C1 and a second capacitor C2. In the DC power supply unit 3, the first capacitor C1 and the second capacitor C2 are connected in series. The DC power supply unit 3 further includes a first DC terminal 31 connected to the positive electrode P1 and a second DC terminal 32 connected to the negative electrode N1. In the DC power supply unit 3, a first end of the first capacitor C1 is connected to the first DC terminal 31, a second end of the first capacitor C1 is connected to a first end of the second capacitor C2, and a second end of the second capacitor C2 is connected to the second DC terminal 32. In the DC power supply unit 3, a connection node between the first capacitor C1 and the second capacitor C2 is the intermediate potential node M1. A DC voltage source E1, for example, may be connected between the first DC terminal 31 and the second DC terminal 32. In that case, an output voltage Vdc of the DC voltage source E1 is applied to between the positive electrode P1 and negative electrode N1 of the DC power supply unit 3. Note that the capacitance of the second capacitor C2 is equal to the capacitance of the first capacitor C1. As used herein, the expression "the capacitance of the second capacitor C2 is equal to the capacitance of the first capacitor C1" refers to not only a situation where the capacitance of the second capacitor C2 is perfectly equal to the capacitance of the first capacitor C1 but also a situation where the capacitance of the second capacitor C2 is equal to or greater than 95% and equal to or less than 105% of the capacitance of the first capacitor C1.

In the following description, as for the plurality of switching circuits 10, the switching circuit 10 included in the inverter circuit 1U will be hereinafter referred to as a "switching circuit 10U," the switching circuit 10 included in the inverter circuit 1V will be hereinafter referred to as a "switching circuit 10V," and the switching circuit 10 included in the inverter circuit 1W will be hereinafter referred to as a "switching circuit 10W" for the sake of convenience of description. In the same way, as for the plurality of output terminals 41, the output terminal 41 included in the inverter circuit 1U will be hereinafter referred to as an "output terminal 41U," the output terminal 41 included in the inverter circuit 1V will be hereinafter referred to as an "output terminal 41V," and the output terminal 41 included in the inverter circuit 1W will be hereinafter referred to as an "output terminal 41W."

In each switching circuit 10, the first switching element Q1, the second switching element Q2, the third switching element Q3, and the fourth switching element Q4 each have a control terminal, a first main terminal, and a second main terminal. The first switching element Q1, the second switching element Q2, the third switching element Q3, and the fourth switching element Q4 of each switching circuit 10 may be, for example, MOSFETs. Thus, in each switching circuit 10, the control terminal, the first main terminal, and the second main terminal of each of the first switching element Q1, the second switching element Q2, the third switching element Q3, and the fourth switching element Q4 are a gate terminal, a drain terminal, and a source terminal, respectively. In each switching circuit 10, the MOSFETs serving as the first switching element Q1, the second switching element Q2, the third switching element Q3, and the fourth switching element Q4 may be, for example, normally OFF n-channel MOSFETs. Note that the MOSFETs may be Si-based MOSFETs, for example. However, this is only an example and should not be construed as limiting. Alternatively, the MOSFETs may also be SiC-based MOSFETs.

In each switching circuit 10, the control terminal of the first switching element Q1 is connected to a corresponding one of the plurality of first gate drivers 61. Also, in each switching circuit 10, the control terminal of the second switching element Q2 is connected to a corresponding one of the plurality of second gate drivers 62. Furthermore, in each switching circuit 10, the control terminal of the third switching element Q3 is connected to a corresponding one of the plurality of third gate drivers 63. Furthermore, in each switching circuit 10, the control terminal of the fourth switching element Q4 is connected to a corresponding one of the plurality of fourth gate drivers 64.

In each switching circuit 10, the first main terminal of the first switching element Q1 is connected to the positive electrode P1 of the DC power supply unit 3, and the second main terminal of the first switching element Q1 is connected to the first main terminal of the second switching element Q2. Also, in each switching circuit 10, the second main terminal of the second switching element Q2 is connected to the first main terminal of the third switching element Q3. Furthermore, in each switching circuit 10, the second main terminal of the third switching element Q3 is connected to the first main terminal of the fourth switching element Q4 and the second main terminal of the fourth switching element Q4 is connected to the negative electrode N1 of the DC power supply unit 3.

In the inverter circuit 1U, the third connection node 13 between the second switching element Q2 and the third switching element Q3 of the switching circuit 10U is connected to the output terminal 41U. In the inverter circuit 1V, the third connection node 13 between the second switching element Q2 and the third switching element Q3 of the switching circuit 10V is connected to the output terminal 41V. In the inverter circuit 1W, the third connection node 13 between the second switching element Q2 and the third switching element Q3 of the switching circuit 10W is connected to the output terminal 41W. To the third connection node 13 of the inverter circuit 1U, connected, via the output terminal 41U, is the U-phase of the AC load RA1, for example. To the third connection node 13 of the inverter circuit 1V, connected, via the output terminal 41V, is the V-phase of the AC load RA1, for example. To the third connection node 13 of the inverter circuit 1W, connected, via the output terminal 41W, is the W-phase of the AC load RA1, for example.

In each inverter circuit 1, the anode of the diode D1 is connected to the second main terminal (source terminal) of the first switching element Q1, and the cathode of the diode D1 is connected to the first main terminal (drain terminal) of the first switching element Q1. Also, in each inverter circuit 1, the anode of the diode D2 is connected to the second main terminal (source terminal) of the second switching element Q2, and the cathode of the diode D2 is connected to the first main terminal (drain terminal) of the second switching element Q2. Furthermore, in each inverter circuit 1, the anode of the diode D3 is connected to the second main terminal (source terminal) of the third switching element Q3, and the cathode of the diode D3 is connected to the first main terminal (drain terminal) of the third switching element Q3. Furthermore, in each inverter circuit 1, the anode of the diode D4 is connected to the second main terminal (source terminal) of the fourth switching element Q4, and the cathode of the diode D4 is connected to the first main terminal (drain terminal) of the fourth switching element Q4.

In each inverter circuit 1, the diode D1 may be replaced with a parasitic diode of a MOSFET serving as the first switching element Q1. Also, in each inverter circuit 1, the diode D2 may be replaced with a parasitic diode of a MOSFET serving as the second switching element Q2. Furthermore, in each inverter circuit 1, the diode D3 may be replaced with a parasitic diode of a MOSFET serving as the third switching element Q3. Furthermore, in each inverter circuit 1, the diode D4 may be replaced with a parasitic diode of a MOSFET serving as the fourth switching element Q4.

In each inverter circuit 1, the cathode of the first diode D5 is connected to the first connection node 11 between the first switching element Q1 and the second switching element Q2. On the other hand, the anode of the first diode D5 is connected to the intermediate potential node M1 of the DC power supply unit 3. In this embodiment, the intermediate potential node M1 is connected to the ground, and therefore, the potential at the intermediate potential node M1 is 0 V. In this case, supposing the voltage across the DC power supply unit 3 is Vdc, the potential at the positive electrode P1 is Vdc/2 and the potential at the negative electrode N1 is -Vdc/2.

The cathode of the second diode D6 is connected to the intermediate potential node M1. The anode of the second diode D6 is connected to the second connection node 12 between the third switching element Q3 and the fourth switching element Q4.

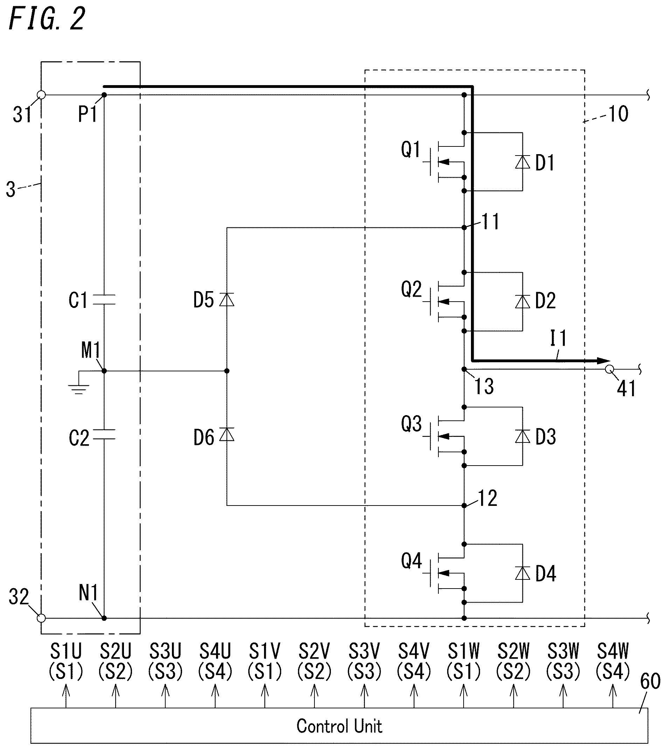

The plurality of first gate drivers 61 are provided one to one for the plurality of first switching elements Q1. Each of the plurality of first gate drivers 61 is connected to the control terminal of a corresponding one of the plurality of first switching elements Q1. Each of the plurality of first gate drivers 61 drives a corresponding one of the plurality of first switching elements Q1. The plurality of first gate drivers 61 are connected to the control unit 60. The control unit 60 outputs a plurality of first control signals S1 (refer to FIG. 2) which are associated one to one with the plurality of first gate drivers 61. Each of the plurality of first gate drivers 61 controls the ON/OFF states of the corresponding first switching element Q1 in accordance with the first control signal S1 supplied thereto.

The plurality of second gate drivers 62 are provided one to one for the plurality of second switching elements Q2. Each of the plurality of second gate drivers 62 is connected to the control terminal of a corresponding one of the plurality of second switching elements Q2. Each of the plurality of second gate drivers 62 drives a corresponding one of the plurality of second switching elements Q2. The plurality of second gate drivers 62 are connected to the control unit 60. The control unit 60 outputs a plurality of second control signals S2 (refer to FIG. 2) which are associated one to one with the plurality of second gate drivers 62. Each of the plurality of second gate drivers 62 controls the ON/OFF states of the corresponding second switching element Q2 in accordance with the second control signal S2 supplied thereto.

The plurality of third gate drivers 63 are provided one to one for the plurality of third switching elements Q3. Each of the plurality of third gate drivers 63 is connected to the control terminal of a corresponding one of the plurality of third switching elements Q3. Each of the plurality of third gate drivers 63 drives a corresponding one of the plurality of third switching elements Q3. The plurality of third gate drivers 63 are connected to the control unit 60. The control unit 60 outputs a plurality of third control signals S3 (refer to FIG. 2) which are associated one to one with the plurality of third gate drivers 63. Each of the plurality of third gate drivers 63 controls the ON/OFF states of the corresponding third switching element Q3 in accordance with the third control signal S3 supplied thereto.

The plurality of fourth gate drivers 64 are provided one to one for the plurality of fourth switching elements Q4. Each of the plurality of fourth gate drivers 64 is connected to the control terminal of a corresponding one of the plurality of fourth switching elements Q4. Each of the plurality of fourth gate drivers 64 drives a corresponding one of the plurality of fourth switching elements Q4. The plurality of fourth gate drivers 64 are connected to the control unit 60. The control unit 60 outputs a plurality of fourth control signals S4 (refer to FIG. 2) which are associated one to one with the plurality of fourth gate drivers 64. Each of the plurality of fourth gate drivers 64 controls the ON/OFF states of the corresponding fourth switching element Q4 in accordance with the fourth control signal S4 supplied thereto.

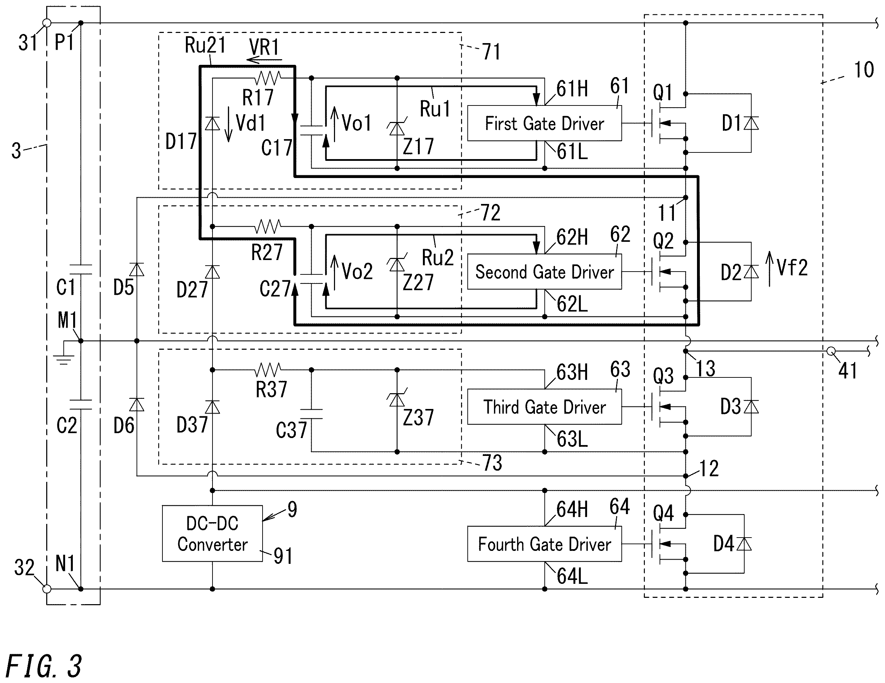

The plurality of first bootstrap circuits 71 are provided one to one for the plurality of first gate drivers 61. Each of the plurality of first bootstrap circuits 71 supplies voltage to a corresponding one of the plurality of first gate drivers 61. Each of the plurality of first bootstrap circuits 71 includes a diode D17, a resistor R17, and a capacitor C17 (hereinafter referred to as a "boosting capacitor C17"). In each of the plurality of first bootstrap circuits 71, the anode of the diode D17 is connected to the positive-side terminal of the power supply unit 9 via the diode D27 and the diode D37, and the cathode of the diode D17 is connected to a first end of the capacitor C17 via the resistor R17. The first end of the capacitor C17 is connected to a higher-potential power supply terminal 61H (refer to FIG. 3) of the corresponding first gate driver 61. A second end of the capacitor C17 is connected to a lower-potential power supply terminal 61L (refer to FIG. 3) of the corresponding first gate driver 61. The first bootstrap circuit 71 supplies, to the corresponding first gate driver 61, a voltage required for the first gate driver 61 to turn ON the first switching element Q1. Each of the plurality of first bootstrap circuits 71 further includes a Zener diode Z17 connected to the capacitor C17 in parallel.

The plurality of second bootstrap circuits 72 are provided one to one for the plurality of second gate drivers 62. Each of the plurality of second bootstrap circuits 72 supplies voltage to a corresponding one of the plurality of second gate drivers 62. Each of the plurality of second bootstrap circuits 72 includes a diode D27, a resistor R27, and a capacitor C27 (hereinafter referred to as a "boosting capacitor C27"). In each of the plurality of second bootstrap circuits 72, the anode of the diode D27 is connected to the positive-side terminal of the power supply unit 9 via the diode D37, and the cathode of the diode D27 is connected to a first end of the capacitor C27 via the resistor R27. The first end of the capacitor C27 is connected to a higher-potential power supply terminal 62H (refer to FIG. 3) of the corresponding second gate driver 62. A second end of the capacitor C27 is connected to a lower-potential power supply terminal 62L (refer to FIG. 3) of the corresponding second gate driver 62. The second bootstrap circuit 72 supplies, to the corresponding second gate driver 62, a voltage required for the second gate driver 62 to turn ON the second switching element Q2. Each of the plurality of second bootstrap circuits 72 further includes a Zener diode Z27 connected to the capacitor C27 in parallel.

The plurality of third bootstrap circuits 73 are provided one to one for the plurality of third gate drivers 63. Each of the plurality of third bootstrap circuits 73 supplies voltage to a corresponding one of the plurality of third gate drivers 63.

Each of the plurality of third bootstrap circuits 73 includes a diode D37, a resistor R37, and a capacitor C37 (hereinafter referred to as a "boosting capacitor C37"). In each of the plurality of third bootstrap circuits 73, the anode of the diode D37 is connected to the positive-side terminal of the power supply unit 9 and the cathode of the diode D37 is connected to a first end of the capacitor C37 via the resistor R37. The first end of the capacitor C37 is connected to a higher-potential power supply terminal 63H (refer to FIG. 3) of the corresponding third gate driver 63. A second end of the capacitor C37 is connected to a lower-potential power supply terminal 63L (refer to FIG. 3) of the corresponding third gate driver 63. The third bootstrap circuit 73 supplies, to the corresponding third gate driver 63, a voltage required for the third gate driver 63 to turn ON the third switching element Q3. Each of the plurality of third bootstrap circuits 73 further includes a Zener diode Z37 connected to the capacitor C37 in parallel.

The power supply unit 9 supplies voltage to the plurality of (three) first bootstrap circuits 71, the plurality of (three) second bootstrap circuits 72, the plurality of (three) third bootstrap circuits 73, and the plurality of (three) fourth gate drivers 64. The power supply unit 9 may be, for example, a DC power supply including an insulating DC-DC converter 91. The positive-side terminal of the power supply unit 9 is connected to the higher-potential power supply terminal 64H (refer to FIG. 3) of each of the plurality of fourth gate drivers 64 and the negative-side terminal of the power supply unit 9 is connected to the lower-potential power supply terminal 64L (refer to FIG. 3) of each of the plurality of fourth gate drivers 64.

The control unit 60 controls the plurality of first gate drivers 61, the plurality of second gate drivers 62, the plurality of third gate drivers 63, and the plurality of fourth gate drivers 64. This allows the control unit 60 to control the plurality of first switching elements Q1, the plurality of second switching elements Q2, the plurality of third switching elements Q3, and the plurality of fourth switching elements Q4. The agent that performs the functions of the control unit 60 includes a computer system. The computer system includes a single or a plurality of computers. The computer system may include a processor and a memory as principal hardware components thereof. The computer system serves as the agent that performs the functions of the control unit 60 according to the present disclosure by making the processor execute a program stored in the memory of the computer system. The program may be stored in advance in the memory of the computer system. Alternatively, the program may also be downloaded through a telecommunications line or be distributed after having been recorded in some non-transitory storage medium such as a memory card, an optical disc, or a hard disk drive (magnetic disk), any of which is readable for the computer system. The processor of the computer system may be made up of a single or a plurality of electronic circuits including a semiconductor integrated circuit (IC) or a large-scale integrated circuit (LSI). Those electronic circuits may be either integrated together on a single chip or distributed on multiple chips, whichever is appropriate. Those multiple chips may be aggregated together in a single device or distributed in multiple devices without limitation.

The control unit 60 outputs a plurality of (three) first control signals S1 (refer to FIG. 2) for controlling the plurality of (three) first switching elements Q1, a plurality of (three) second control signals S2 (refer to FIG. 2) for controlling the plurality of (three) second switching elements Q2, a plurality of (three) third control signals S3 (refer to FIG. 2) for controlling the plurality of third switching elements Q3, and a plurality of (three) fourth control signals S4 for controlling the plurality of (three) fourth switching elements Q4. Note that in FIG. 2, only one of the three inverter circuits 1 (refer to FIG. 1) is shown with illustration of the other two inverter circuits 1 omitted. Also, in FIG. 2, illustration of the plurality of first gate drivers 61, the plurality of second gate drivers 62, the plurality of third gate drivers 63, the plurality of fourth gate drivers 64, the plurality of first bootstrap circuits 71, the plurality of second bootstrap circuits 72, the plurality of third bootstrap circuits 73, and the power supply unit 9 that are shown in FIG. 1 is omitted. Furthermore, in FIG. 3, only one of the three inverter circuits 1 (refer to FIG. 1) is shown with illustration of the other two inverter circuits 1 omitted. Also, in FIG. 3, illustration of the two first gate drivers 61, the two second gate drivers 62, the two third gate drivers 63, the two fourth gate drivers 64, the two first bootstrap circuits 71, the two second bootstrap circuits 72, and the two third bootstrap circuits 73 that are shown in FIG. 1 is omitted.

The three first control signals S1 are a first control signal S1U for controlling the first switching element Q1 of the switching circuit 10U, a first control signal S1V for controlling the first switching element Q1 of the switching circuit 10V, and a first control signal S1W for controlling the first switching element Q1 of the switching circuit 10W.

The three second control signals S2 are a second control signal S2U for controlling the second switching element Q2 of the switching circuit 10U, a second control signal S2V for controlling the second switching element Q2 of the switching circuit 10V, and a second control signal S2W for controlling the second switching element Q2 of the switching circuit 10W.

The three third control signals S3 are a third control signal S3U for controlling the third switching element Q3 of the switching circuit 10U, a third control signal S3V for controlling the third switching element Q3 of the switching circuit 10V, and a third control signal S3W for controlling the third switching element Q3 of the switching circuit 10W.

The three fourth control signals S4 are a fourth control signal S4U for controlling the fourth switching element Q4 of the switching circuit 10U, a fourth control signal S4V for controlling the fourth switching element Q4 of the switching circuit 10V, and a fourth control signal S4W for controlling the fourth switching element Q4 of the switching circuit 10W.

Each of the plurality of first control signals S1, the plurality of second control signals S2, the plurality of third control signals S3, and the plurality of fourth control signals S4 may be, for example, a signal having a potential level that alternates between a first potential level (hereinafter referred to as a "low level") and a second potential level (hereinafter referred to as a "high level") higher than the first potential level.

The first potential level may be 0 V, for example, and the second potential level is a potential level higher than a gate threshold voltage of the MOSFET. That is to say, in each of the plurality of control signals (including the plurality of first control signals S1, the plurality of second control signals S2, the plurality of third control signals S3, and the plurality of fourth control signals S4), the first potential level is a potential level for turning OFF the switching element associated with the control signal and the second potential level is a potential level for turning ON the switching element associated with the control signal.

Each of the plurality of first switching elements Q1 turns ON when its associated first control signal S1 has high level and turns OFF when its associated first control signal S1 has low level. Each of the plurality of second switching elements Q2 turns ON when its associated second control signal S2 has high level and turns OFF when its associated second control signal S2 has low level. Each of the plurality of third switching elements Q3 turns ON when its associated third control signal S3 has high level and turns OFF when its associated third control signal S3 has low level. Each of the plurality of fourth switching elements Q4 turns ON when its associated fourth control signal S4 has high level and turns OFF when its associated fourth control signal S4 has low level.

In the power converter 100, each of the plurality of inverter circuits 1 is controlled toward one of a first switching state, a second switching state, a third switching state, or a fourth switching state. That is to say, in the power converter 100, in each of the three inverter circuits 1U, 1V, 1W, the switching state of the switching circuit 10 thereof is controlled toward any one of the first, second, third, and fourth switching states. The first, second, third, and fourth switching states are different from each other in the combination of ON/OFF states of the first to fourth switching elements Q1-Q4. In each of the plurality of inverter circuits 1, its output voltage in the first switching state, its output voltage in the second switching state, and its output voltage in the third switching state are different from each other. That is to say, in each of the plurality of inverter circuits 1, the potential level of the output voltage changes in three levels according to the states of the first to fourth switching elements Q1-Q4. Note that as for the output voltages of the plurality of inverter circuits 1, the output voltage of the U-phase inverter circuit 1U, the output voltage of the V-phase inverter circuit 1V, and the output voltage of the W-phase inverter circuit 1W have mutually different phases.

The first switching state herein refers to a combination of ON/OFF states of the first to fourth switching elements Q1-Q4 where the first switching element Q1 and the second switching element Q2 are both ON and the third switching element Q3 and the fourth switching element Q4 are both OFF. When controlled toward the first switching state, each of the plurality of inverter circuits 1 may deliver an output voltage having a potential level at the positive electrode P1 of the DC power supply unit 3. In each of the plurality of inverter circuits 1 in the first switching state, the potential at the third connection node 13 is as high as the potential level (e.g., Vdc/2) at the positive electrode P1 of the DC power supply unit 3.

The second switching state herein refers to a combination of ON/OFF states of the first to fourth switching elements Q1-Q4 where the first switching element Q1 and the fourth switching element Q4 are both OFF and the second switching element Q2 and the third switching element Q3 are both ON. When controlled toward the second switching state, each of the plurality of inverter circuits 1 may deliver an output voltage having a potential level at the intermediate potential node M1 of the DC power supply unit 3. In each of the plurality of inverter circuits 1 in the second switching state, the potential at the third connection node 13 is as high as the potential level (e.g., 0) at the intermediate potential node M1.

The third switching state herein refers to a combination of ON/OFF states of the first to fourth switching elements Q1-Q4 where the first switching element Q1 and the second switching element Q2 are both OFF and the third switching element Q3 and the fourth switching element Q4 are both ON. When controlled toward the third switching state, each of the plurality of inverter circuits 1 may deliver an output voltage having a potential level at the negative electrode N1 of the DC power supply unit 3. In each of the plurality of inverter circuits 1 in the third switching state, the potential at the third connection node 13 is as high as the potential level (e.g., -Vdc/2) at the negative electrode N1 of the DC power supply unit 3.

The fourth switching state herein refers to a combination of ON/OFF states of the first to fourth switching elements Q1-Q4 where the second switching element Q2 and the fourth switching element Q4 are both ON and the first switching element Q1 and the third switching element Q3 are both OFF. When controlled toward the fourth switching state, each of the plurality of inverter circuits 1 may deliver an output voltage having a potential level at the intermediate potential node M1 of the DC power supply unit 3. In each of the plurality of inverter circuits 1 in the fourth switching state, the potential at the third connection node 13 is as high as the potential level (e.g., 0) at the intermediate potential node M1.

When the switching circuit 10 of one inverter circuit 1 is in the first switching state, a current I1 flows along a path that passes through the positive electrode P1 of the DC power supply unit 3, the first switching element Q1, the second switching element Q2, the third connection node 13, and the output terminal 41 in this order as shown in FIG. 2 to make the voltage value of the output voltage for the AC load RA1 (refer to FIG. 1) approximately equal to Vdc/2.

In addition, when the switching circuit 10 of the inverter circuit 1 is in the first switching state, a voltage required for the first gate driver 61 to turn ON the first switching element Q1 is supplied from the capacitor C17 of the first bootstrap circuit 71 to the first gate driver 61. Thus, electricity is discharged from the capacitor C17 of the first bootstrap circuit 71 through a discharging path Ru1 that passes through the capacitor C17, the higher-potential power supply terminal 61H of the first gate driver 61, the lower-potential power supply terminal 61L of the first gate driver 61, and the capacitor C17 in this order as shown in FIG. 3. As a result, in the first bootstrap circuit 71, the voltage across the capacitor C17 falls with the passage of time.

Furthermore, when the switching circuit 10 of the inverter circuit 1 is in the first switching state, a voltage required for the second gate driver 62 to turn ON the second switching element Q2 is supplied from the capacitor C27 of the second bootstrap circuit 72 to the second gate driver 62. Thus, electricity is discharged from the capacitor C27 of the second bootstrap circuit 72 through a discharging path Ru2 that passes through the capacitor C27, the higher-potential power supply terminal 62H of the second gate driver 62, the lower-potential power supply terminal 62L of the second gate driver 62, and the capacitor C27 in this order. As a result, in the second bootstrap circuit 72, the voltage across the capacitor C27 falls with the passage of time.

Furthermore, when the switching circuit 10 of the inverter circuit 1 is in the first switching state, the capacitor C17 is charged with the electric charges in the capacitor C27 if a first condition is satisfied. If the voltage across the capacitor C17 is Vo1, the voltage across the capacitor C27 is Vo2, the voltage across the diode D17 is Vd1, the voltage across the resistor R17 is VR1, and the voltage across the second switching element Q2 is Vf2 as shown in FIG. 3, the first condition is Vo2 > (Vo1 + Vd1 + VR1 + Vf2). The charging path Ru21 for charging the capacitor C17 with the electric charges in the capacitor C27 is a path that passes through the capacitor C27, the resistor R27, the diode D17, the resistor R17, the capacitor C17, the first connection node 11, the second switching element Q2, and the capacitor C27 in this order.

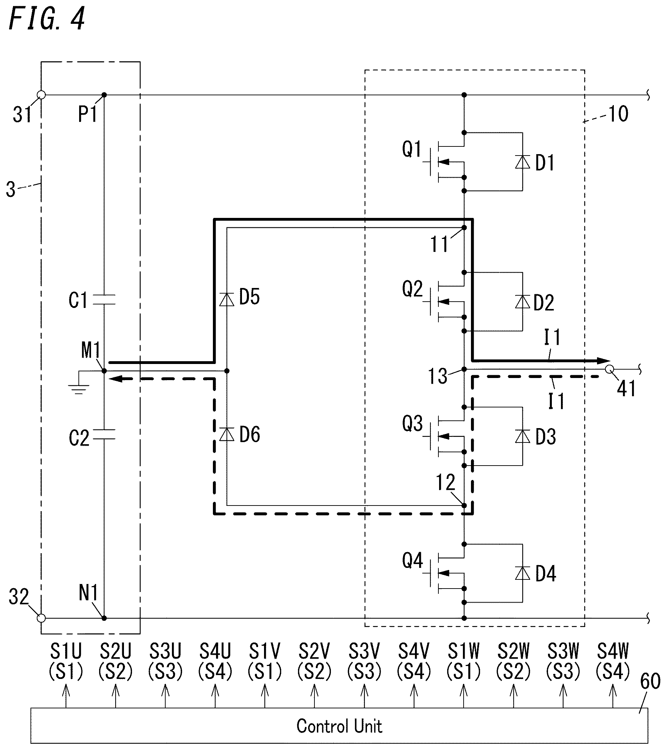

On the other hand, when the switching circuit 10 of the inverter circuit 1 is in the second switching state and the polarity of the output current is positive, a current I1 flows along the path (i.e., the path indicated by the bold solid-line arrow) that passes through the intermediate potential node M1 of the DC power supply unit 3, the fifth diode D5, the second switching element Q2, the third connection node 13, and the output terminal 41 in this order as shown in FIG. 4, to make the voltage value of the output voltage for the AC load RA1 equal to zero. More specifically, when the switching circuits 10U, 10V, 10W are in the second switching state, the third switching state, and the third switching state, respectively, the current I1 flows along the path that passes through the intermediate potential node M1 of the DC power supply unit 3, the first diode D5 of the inverter circuit 1U, the second switching element Q2 of the switching circuit 10U, the third connection node 13, and the output terminal 41 in this order.

Alternatively, when the switching circuit 10 of the inverter circuit 1 is in the second switching state and the polarity of the output current is negative, a current I1 may also flow along the path that passes through, for example, the output terminal 41, the third connection node 13, the third switching element Q3, the second connection node 12, and the sixth diode D6 in this order (i.e., the path indicated by the bold dashed-line arrow) as shown in FIG. 4, to make the voltage value of the output voltage for the AC load RA1 equal to zero. More specifically, when the switching circuits 10U, 10V, 10W are in the second switching state, the second switching state, and the first switching state, respectively, the current I1 flows along the path that passes through the output terminal 41 of the inverter circuit 1U, the third connection node 13, the third switching element Q3, the second connection node 12, and the sixth diode D6 in this order (i.e., the path indicated by the bold dashed-line arrow) to make the voltage value of the output voltage for the AC load RA1 equal to zero.

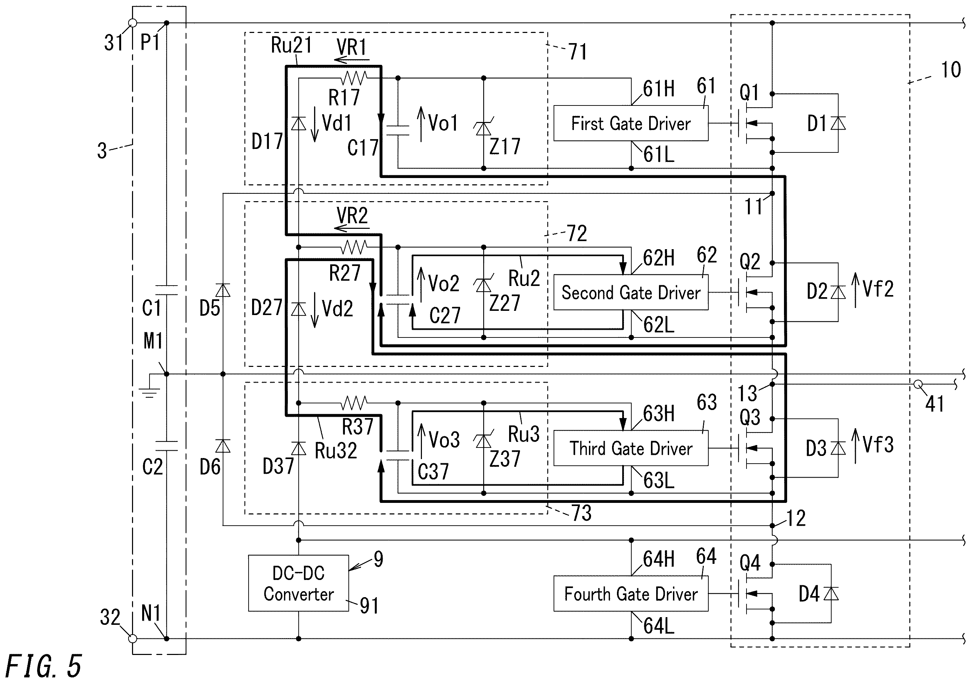

Furthermore, when the switching circuit 10 of the inverter circuit 1 is in the second switching state, a voltage required for the second gate driver 62 to turn ON the second switching element Q2 is supplied from the capacitor C27 of the second bootstrap circuit 72 to the second gate driver 62. Thus, electricity is discharged from the capacitor C27 of the second bootstrap circuit 72 through a discharging path Ru2 that passes through the capacitor C27, the higher-potential power supply terminal 62H of the second gate driver 62, the lower-potential power supply terminal 62L of the second gate driver 62, and the capacitor C27 in this order as shown in FIG. 5. In addition, when the switching circuit 10 of the inverter circuit 1 is in the second switching state, a voltage required for the third gate driver 63 to turn ON the third switching element Q3 is supplied from the capacitor C37 of the third bootstrap circuit 73 to the third gate driver 63. Thus, electricity is discharged from the capacitor C37 of the third bootstrap circuit 73 through a discharging path Ru3 that passes through the capacitor C37, the higher-potential power supply terminal 63H of the third gate driver 63, the lower-potential power supply terminal 63L of the third gate driver 63, and the capacitor C37 in this order.

Furthermore, when the switching circuit 10 of the inverter circuit 1 is in the second switching state, the capacitor C27 is charged with electric charges in the capacitor C37 if a second condition is satisfied and the capacitor C17 is charged with electric charges in the capacitor C27 if a third condition is satisfied. If the voltages across the capacitors C17, C27, C37 are Vo1, Vo2, Vo3, respectively, the voltages across the diodes D17, D27 are Vd1 and Vd2, respectively, the voltages across the resistors R17, R27 are VR1, VR2, respectively, and the voltages across the second switching element Q2 and the third switching element Q3 are Vf2, Vf3, respectively, as shown in FIG. 5, the second condition is Vo3 > (Vo2 + Vd2 + VR2 + Vf3). The third condition is Vo2 > (Vo1 + Vd1 + VR1 + Vf2). The charging path Ru32 for charging the capacitor C27 with the electric charges in the capacitor C37 is a path that passes through the capacitor C37, the resistor R37, the diode D27, the resistor R27, the capacitor C27, the third connection node 13, the third switching element Q3, and the capacitor C37 in this order. The charging path Ru21 for charging the capacitor C17 with the electric charges in the capacitor C27 is a path that passes through the capacitor C27, the resistor R27, the diode D17, the resistor R17, the capacitor C17, the first connection node 11, the second switching element Q2, and the capacitor C27 in this order.

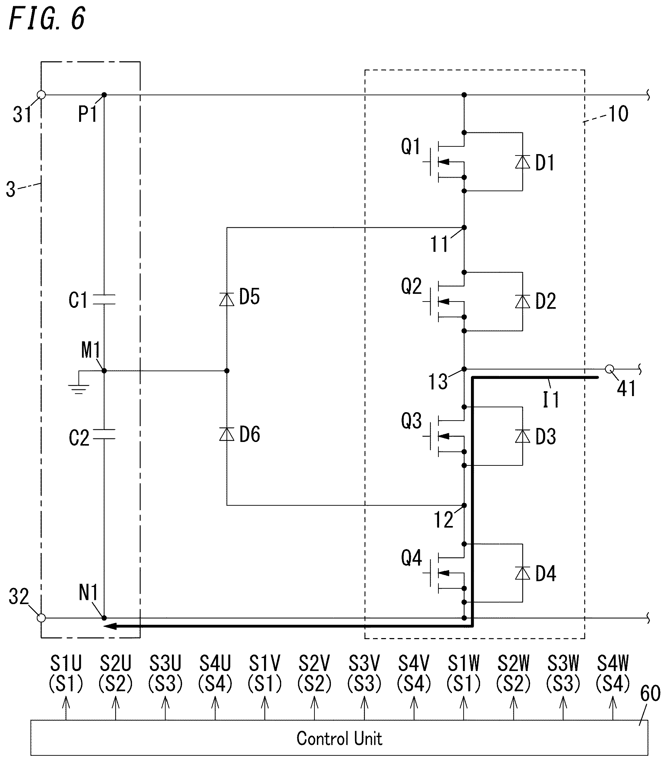

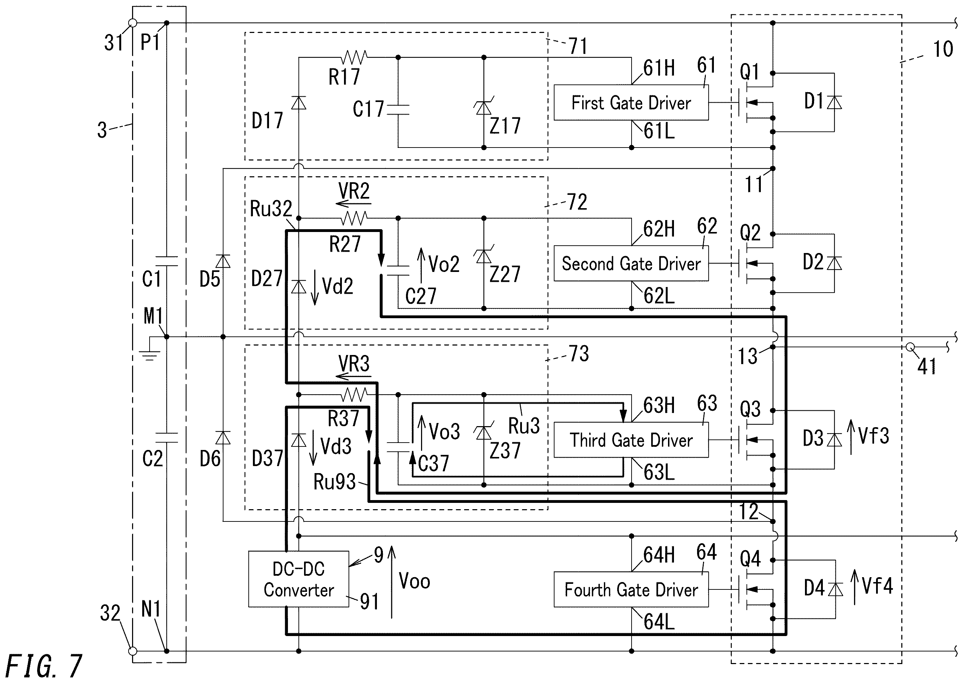

Meanwhile, when the switching circuit 10 of the inverter circuit 1 is in the third switching state, a current I1 flows along the path that passes through the output terminal 41, the third connection node 13, the third switching element Q3, the fourth switching element Q4, and the negative electrode N1 of the DC power supply unit 3 in this order as shown in FIG. 6 to make the voltage value of the output voltage for the AC load RA1 equal to -Vdc/2. In addition, when the switching circuit 10 of the inverter circuit 1 is in the third switching state, the capacitor C27 of the second bootstrap circuit 72 (refer to FIG. 1) is charged with electric charges in the capacitor C37, and therefore, the voltage at the capacitor C27 rises with the passage of time to eventually make the capacitor C27 fully charged. Furthermore, when the switching circuit 10 of the inverter circuit 1 is in the third switching state, a voltage required for the third gate driver 63 to turn ON the third switching element Q3 is supplied from the capacitor C37 of the third bootstrap circuit 73 to the third gate driver 63. Thus, electricity is discharged from the capacitor C37 of the third bootstrap circuit 73 through a discharging path Ru3 that passes through the capacitor C37, the higher-potential power supply terminal 63H of the third gate driver 63, the lower-potential power supply terminal 63L of the third gate driver 63, and the capacitor C37 in this order as shown in FIG. 7. Furthermore, when the switching circuit 10 of the inverter circuit 1 is in the third switching state, the capacitor C37 is charged with electricity by the power supply unit 9 if a fourth condition is satisfied and the capacitor C27 is charged with electric charges in the capacitor C37 if a fifth condition is satisfied. If the voltage across the power supply unit 9 is Voo, the voltages across the capacitors C27, C37 are Vo2, Vo3, respectively, the voltages across the diodes D27, D37 are Vd2, Vd3, respectively, the voltages across the resistors R27, R37 are VR2, VR3, respectively, and the voltages across the third switching element Q3 and the fourth switching element Q4 are Vf3, Vf4, respectively, as shown in FIG. 7, the fourth condition is Voo > (Vo3 + Vd3 + VR3 + Vf4) and the fifth condition is Vo3 > (Vo2 + Vd2 + VR2 + Vf3). The charging path Ru93 for charging the capacitor C37 with the electric charges in the power supply unit 9 is a path that passes through the positive-side terminal of the power supply unit 9, the diode D37, the resistor R37, the capacitor C37, the second connection node 12, the fourth switching element Q4, and the negative-side terminal of the power supply unit 9 in this order. The charging path Ru32 for charging the capacitor C27 with the electric charges in the capacitor C37 is a path that passes through the capacitor C37, the resistor R37, the diode D27, the resistor R27, the capacitor C27, the third connection node 13, the third switching element Q3, and the capacitor C37 in this order.

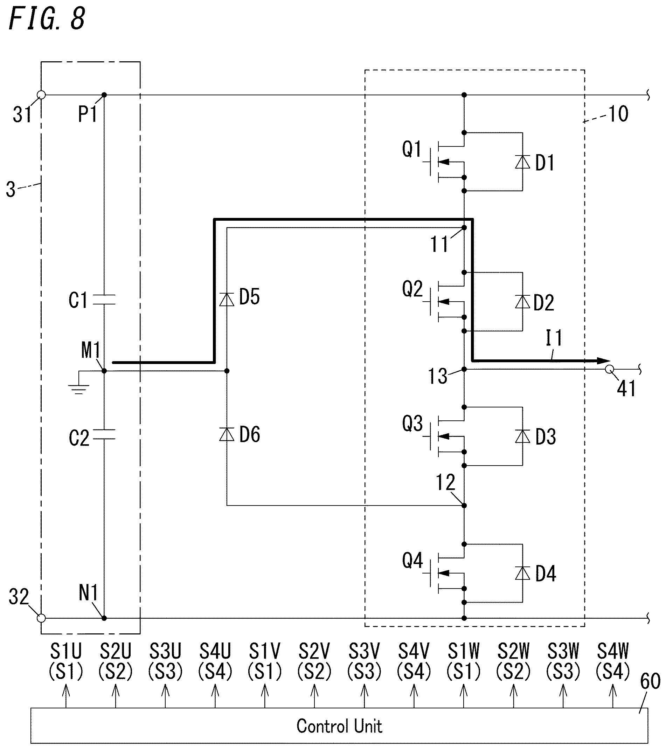

When the switching circuit 10 of the inverter circuit 1 is in the fourth switching state, the current I1 flows along a path that passes through the intermediate potential node M1 of the DC power supply unit 3, the first diode D5, the second switching element Q2, the third connection node 13, and the output terminal 41 in this order as shown in FIG. 8 to make the voltage value of the output voltage for the AC load RA1 equal to zero.

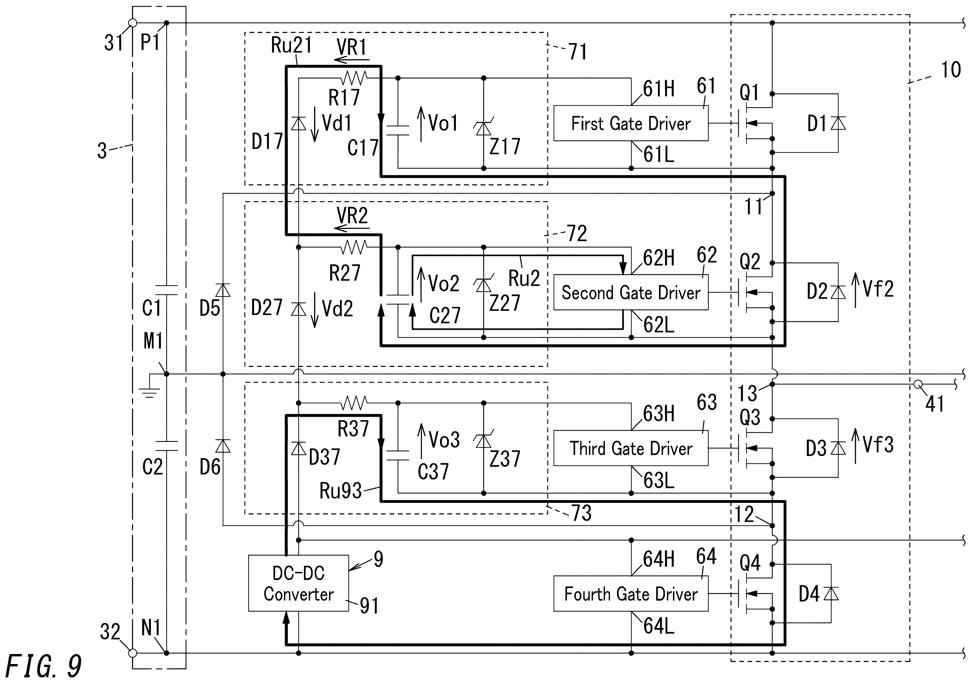

In addition, when the switching circuit 10 of the inverter circuit 1 is in the fourth switching state, a voltage required for the second gate driver 62 to turn ON the second switching element Q2 is supplied from the capacitor C27 of the second bootstrap circuit 72 to the second gate driver 62. Thus, electricity is discharged from the capacitor C27 of the second bootstrap circuit 72 through a discharging path Ru2 that passes through the capacitor C27, the higher-potential power supply terminal 62H of the second gate driver 62, the lower-potential power supply terminal 62L of the second gate driver 62, and the capacitor C27 in this order as shown in FIG. 9. Furthermore, when the switching circuit 10 of the inverter circuit 1 is in the fourth switching state, a voltage required for the fourth gate driver 64 to turn ON the fourth switching element Q4 is supplied from the power supply unit 9 to the fourth gate driver 64. Furthermore, when the switching circuit 10 of the inverter circuit 1 is in the fourth switching state, the capacitor C37 is charged with electricity by the power supply unit 9. As shown in FIG. 9, a charging path Ru93 for charging the capacitor C37 with electricity by the power supply unit 9 is a path that passes through the positive-side terminal of the power supply unit 9, the diode D37, the resistor R37, the capacitor C37, the second connection node 12, the fourth switching element Q4, and the negative-side terminal of the power supply unit 9 in this order.

The control unit 60 has a first control mode, a second control mode, and a third control mode.

In the first control mode, the control unit 60 controls the first, second, third, and fourth switching elements Q1, Q2, Q3, Q4 such that the first switching element Q1 is ON, the second switching element Q2 is ON, the third switching element Q3 is OFF, and the fourth switching element Q4 is OFF. More specifically, in the first control mode, the control unit 60 controls the first switching element Q1, the second switching element Q2, the third switching element Q3, and the fourth switching element Q4 to allow the switching circuit 10 to operate in the first switching state.

In the second control mode, the control unit 60 controls the first, second, third, and fourth switching elements Q1, Q2, Q3, Q4 such that the first switching element Q1 is OFF, the second switching element Q2 is ON, the third switching element Q3 is ON, and the fourth switching element Q4 is OFF. More specifically, in the second control mode, the control unit 60 controls the first switching element Q1, the second switching element Q2, the third switching element Q3, and the fourth switching element Q4 to allow the switching circuit 10 to operate in the second switching state.

In the third control mode, the control unit 60 controls the first, second, third, and fourth switching elements Q1, Q2, Q3, Q4 such that the first switching element Q1 is OFF, the second switching element Q2 is ON, the third switching element Q3 is OFF, and the fourth switching element Q4 is ON. More specifically, in the third control mode, the control unit 60 controls the first switching element Q1, the second switching element Q2, the third switching element Q3, and the fourth switching element Q4 to allow the switching circuit 10 to operate in the fourth switching state.

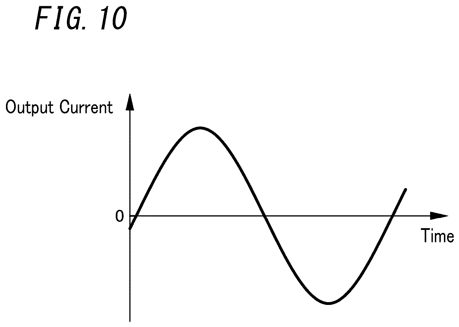

If, as for the polarity of an output current (current I1) flowing through the output terminal 41, the polarity of the current flowing in one direction from the third connection node 13 toward the output terminal 41 is defined to be positive and the polarity of the current flowing in the opposite direction from the output terminal 41 toward the third connection node 13 is defined to be negative, then the output current will have a sinusoidal waveform as shown in FIG. 10, for example. Note that a U-phase output current, a V-phase output current, and a W-phase output current will be currents with sinusoidal waveforms, of which the phases are different from each other by 120 degrees, for example.

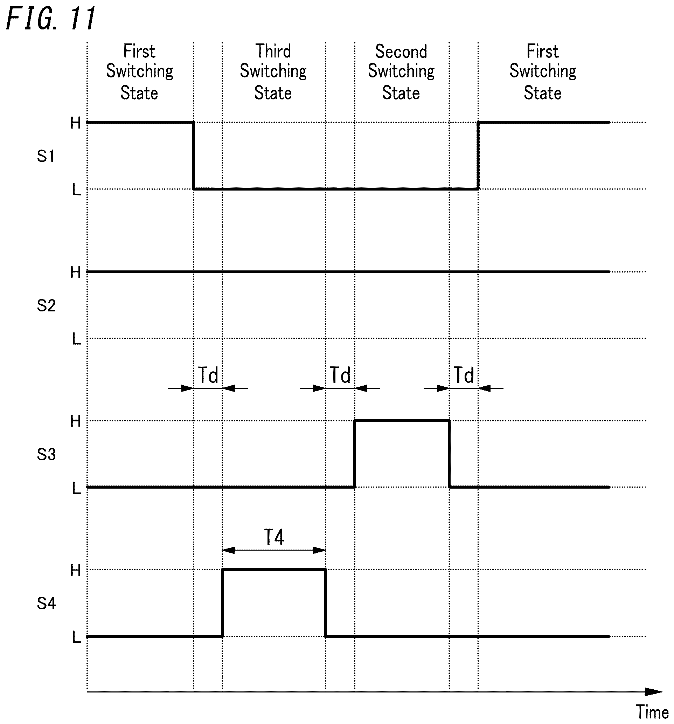

If the polarity of the current flowing through the output terminal 41 is positive, the control unit 60 repeats the first control mode and the second control mode alternately. In this embodiment, when making a transition from the first control mode to the second control mode, the control unit 60 performs control in the third control mode between the first control mode and the second control mode as shown in FIG. 11. Thus, the control unit 60 makes a transition to the first control mode via the second control mode immediately after having gone through the third control mode. Note that in FIG. 11, as for the respective potential levels of a first control signal S1, a second control signal S2, a third control signal S3, and a fourth control signal S4, the low level is designated by "L" and the high level is designated by "H."

The control unit 60 also sets a dead time period Td between a period in which the potential level of the control signal S4 is high level and a period in which the potential level of the control signal S3 is high level to prevent the respective ON periods of the fourth switching element Q4 and the third switching element Q3 from overlapping with each other. In addition, the control unit 60 also sets a dead time period Td between a period in which the potential level of the control signal S1 is high level and the period in which the potential level of the control signal S4 is high level to prevent the respective ON periods of the first switching element Q1 and the fourth switching element Q4 from overlapping with each other. Furthermore, the control unit 60 further sets a dead time period Td between the period in which the potential level of the control signal S3 is high level and the period in which the potential level of the control signal S3 is high level to prevent the respective ON periods of the third switching element Q3 and the first switching element Q1 from overlapping with each other. Optionally, the length of the dead time period Td may be equal to zero. Furthermore, in the power converter 100 according to this embodiment, the control unit 60 makes, in the third control mode, the length T4 of the ON period of the fourth switching element Q4 equal to or greater than 90% and equal to or less than 110% of a CR time constant of the third bootstrap circuit 73 for supplying voltage to the third gate driver 63. In the power converter 100 according to this embodiment, the CR time constant of the third bootstrap circuit 73 is determined by the capacitance of the capacitor C37 of the third bootstrap circuit 73 and the resistance value of the resistor R37.

The control unit 60 further has a fourth control mode. In the fourth control mode, the control unit 60 controls the first, second, third, and fourth switching elements Q1, Q2, Q3, Q4 such that the first switching element Q1 is OFF, the second switching element Q2 is OFF, the third switching element Q3 is ON, and the fourth switching element Q4 is ON. More specifically, in the fourth control mode, the control unit 60 controls the first switching element Q1, the second switching element Q2, the third switching element Q3, and the fourth switching element Q4 to allow the switching circuit 10 to operate in the third switching state.

If the polarity of the output current (current I1) flowing through the output terminal 41 is negative, the control unit 60 repeats the second control mode and the fourth control mode alternately.

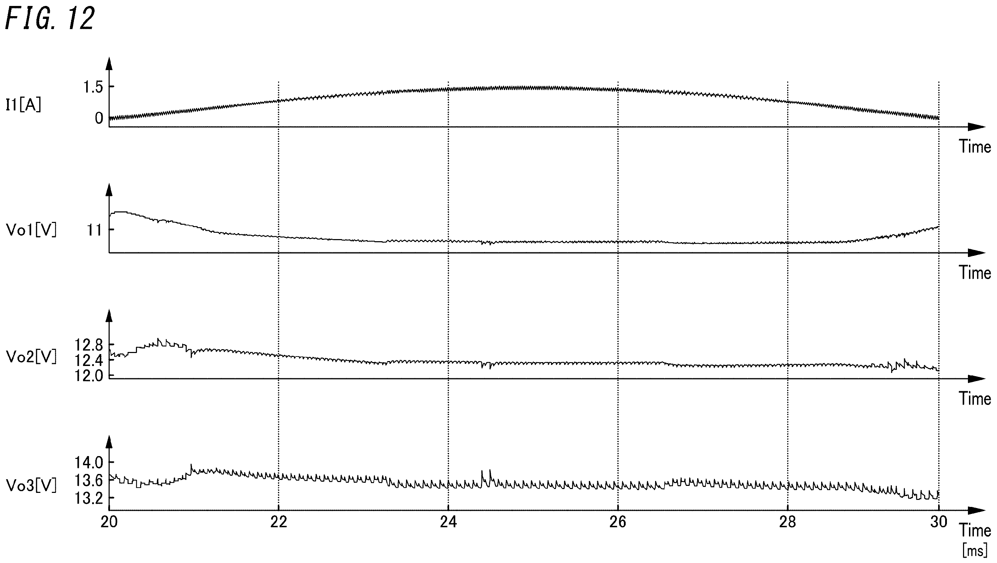

FIG. 12 shows the respective waveforms of the current I1, the voltage Vo1 across the capacitor C17, the voltage Vo2 across the capacitor C27, and the voltage Vo3 across the capacitor C37 for a period in which the polarity of the output current flowing through the output terminal 41 is positive in an example of the present disclosure. Note that in the example shown in FIG. 12, the switching frequency is set at 20 kHz, and the frequency of the output current (current I1) is set at 50 Hz. In addition, in the example shown in FIG. 12, the length of the dead time period Td is set at zero.

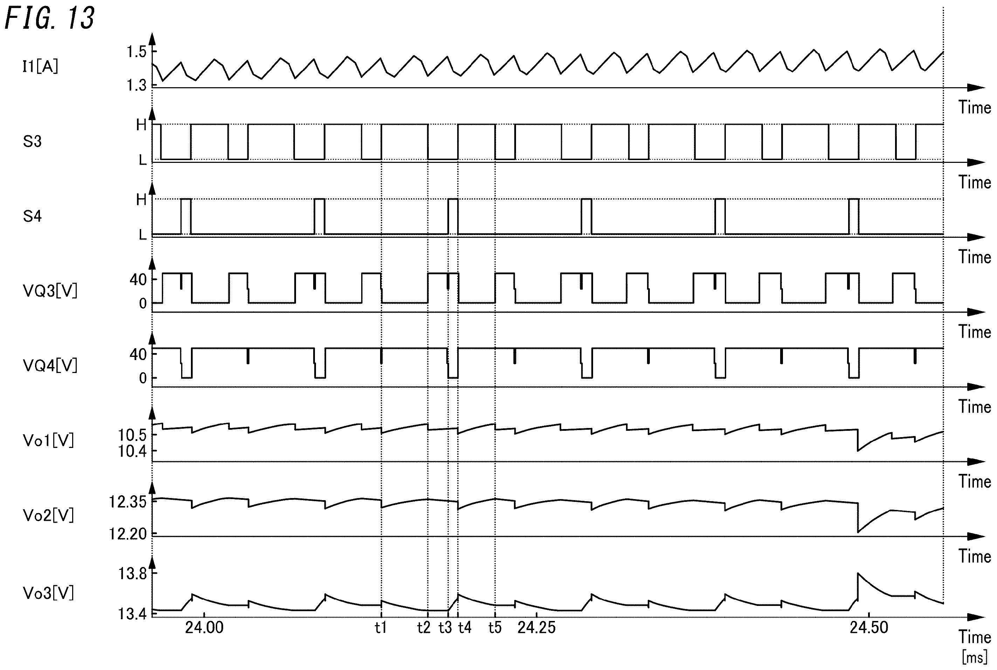

FIG. 13 shows the respective waveforms of the current I1, the control signal S3, the control signal S4, the voltage VQ3 across the third switching element Q3, the voltage VQ4 across the fourth switching element Q4, the voltage Vo1 across the capacitor C17, the voltage Vo2 across the capacitor C27, and the voltage Vo3 across the capacitor C37 for a part of the period in which the polarity of the output current flowing through the output terminal 41 is positive in an example of the present disclosure.

In FIG. 13, the period between a time t1 and a time t2 is a period in which the control mode of the control unit 60 is the second control mode. In FIG. 13, the period between the time t2 and a time t3 is a period in which the control mode of the control unit 60 is the first control mode. In FIG. 13, the period between the time t3 and a time t4 is a period in which the control mode of the control unit 60 is the third control mode. In FIG. 13, the period between the time t4 and the time t5 is a period in which the control mode of the control unit 60 is the second control mode.

As can be seen from FIG. 13, in every period in which the control unit 60 is performing control in the third control mode, the capacitor C37 of the third bootstrap circuit 73 is charged with electricity and the decrease in voltage at the third bootstrap circuit 73 (i.e., the voltage Vo3 across the capacitor C37) is made less steep.

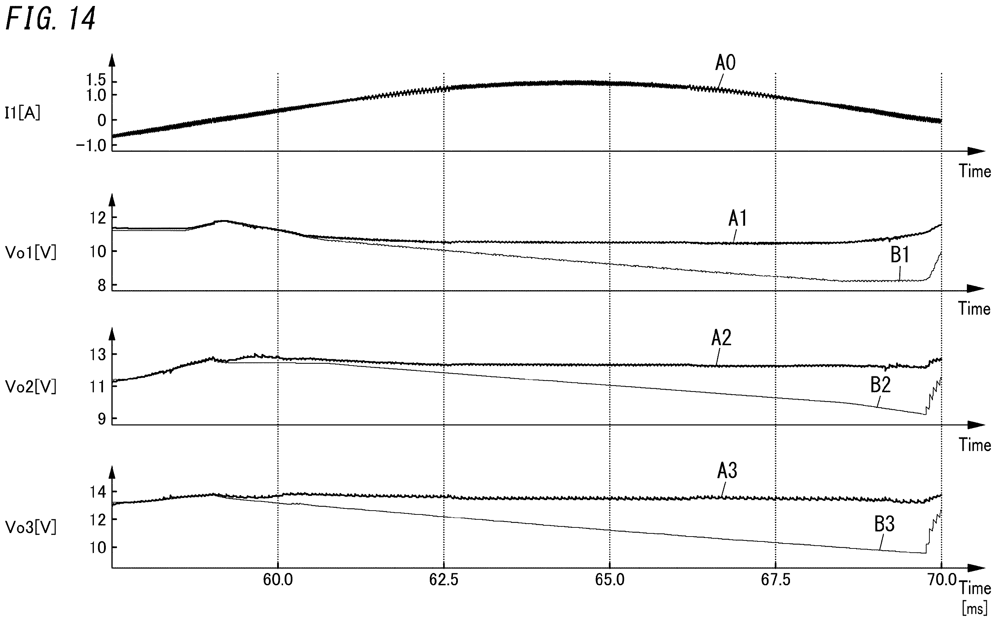

FIG. 14 shows the respective waveforms of the current I1, the voltage Vo1 across the capacitor C17 of the first bootstrap circuit 71, the voltage Vo2 across the capacitor C27 of the second bootstrap circuit 72, and the voltage Vo3 across the capacitor C37 of the third bootstrap circuit 73 for the example of the present disclosure and a comparative example. In the comparative example, the control unit 60 does not have the third control mode and repeats the first control mode and the second control mode alternately in a period in which the output current is positive. In FIG. 14, A0 indicates the waveform of the current I1 according to the example of the present disclosure. The current I1 according to the comparative example does not decrease from the current I1 according to the example of the present disclosure but overlaps with A0, and therefore, not shown in FIG. 14. As for the voltage Vo1 across the capacitor C17 of the first bootstrap circuit 71, A1 indicates the waveform according to the example of the present disclosure and B1 indicates the waveform according to the comparative example. As for the voltage Vo2 across the capacitor C27 of the second bootstrap circuit 72, A2 indicates the waveform according to the example of the present disclosure and B2 indicates the waveform according to the comparative example. As for the voltage Vo3 across the capacitor C37 of the third bootstrap circuit 73, A3 indicates the waveform according to the example of the present disclosure and B3 indicates the waveform according to the comparative example.

As can be seen from FIG. 14, the example of the present disclosure may make the respective decreases in the voltage Vo1 across the capacitor C17, the voltage Vo2 across the capacitor C27, and the voltage Vo3 across the capacitor C37 less sharp than in the comparative example without affecting the output current. Thus, the example of the present disclosure allows for maintaining voltages required for the first gate driver 61, the second gate driver 62, and the third gate driver 63.

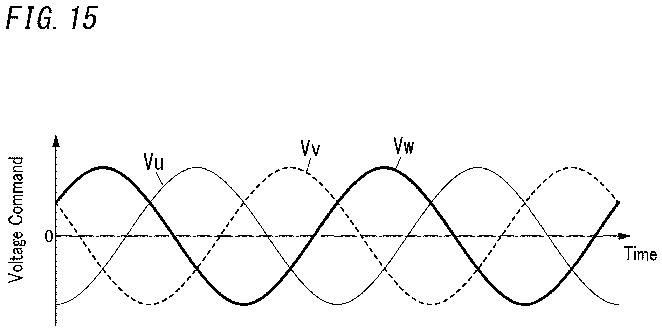

The control unit 60 employs the voltage vector control as its control scheme. The voltage vector control to be performed by the control unit 60 will be described with reference to FIGS. 15-18.

The control unit 60 generates, in accordance with voltage commands Vu, Vv, Vw (refer to FIG. 15) about the respective output voltages of the inverter circuits 1U, 1V, 1W, first to fourth control signals S1U-S4U, first to fourth control signals S1V-S4V, and first to fourth control signals S1W-S4W. The first to fourth control signals S1U-S4U are respectively first to fourth control signals S1-S4 for the first to fourth switching elements Q1-Q4 of the inverter circuit 1U. The first to fourth control signals S1V-S4V are respectively first to fourth control signals S1-S4 for the first to fourth switching elements Q1-Q4 of the inverter circuit 1V. The first to fourth control signals S1W-S4W are respectively first to fourth control signals S1-S4 for the first to fourth switching elements Q1-Q4 of the inverter circuit 1W.

As shown in FIG. 15, voltage commands Vu, Vv, Vw are sinusoidal wave signals, of which the phases are different from each other by 120 degrees, for example, and have values (voltage command values) that change with time. Note that the voltage commands Vu, Vv, Vw each have one cycle of the same length. Optionally, the control unit 60 may perform proportional-integral (PI) control on the voltage commands Vu, Vv, Vw in accordance with the information provided by a detection unit 8 (refer to FIG. 1) for detecting the state of the AC load RA1. If the AC load RA1 is a three-phase motor, the information provided by the detection unit 8 includes, for example, information about detection results obtained by a plurality of current sensors for detecting output currents flowing through the U-, V- and W-phases of the AC load RA1 and/or information about the detection results obtained by an encoder for detecting the number of revolutions, the rotational angle, and other parameters of the three-phase motor.

Next, it will be described how one of the three inverter circuits 1 (e.g., the U-phase inverter circuit 1U) operates. The V-phase inverter circuit 1V and the W-phase inverter circuit 1W operate in the same way as the U-phase inverter circuit 1U. The respective output voltages of the U-phase inverter circuit 1U, the V-phase inverter circuit 1V, and the W-phase inverter circuit 1W have mutually different phases.

The control unit 60 controls the plurality of first gate drivers 61, the plurality of second gate drivers 62, the plurality of third gate drivers 63, and the plurality of fourth gate drivers 64 by performing voltage vector control.

Next, it will be described in further detail how the control unit 60 performs the voltage vector control.

The control unit 60 stores, in advance, a group of voltage vectors. Each of the group of voltage vectors is defined by a combination of respective potential levels at connection nodes (third connection nodes 13), at each of which the second switching element Q2 and the third switching element Q3 are connected to each other in a corresponding one of the plurality of inverter circuits 1. In other words, each of the group of voltage vectors is defined by the switching state of the switching circuit 10U corresponding to the U-phase, the switching state of the switching circuit 10V corresponding to the V-phase, and the switching state of the switching circuit 10W corresponding to the W-phase. The number of voltage vectors included in one group of voltage vectors is $3^3$ (= 27).

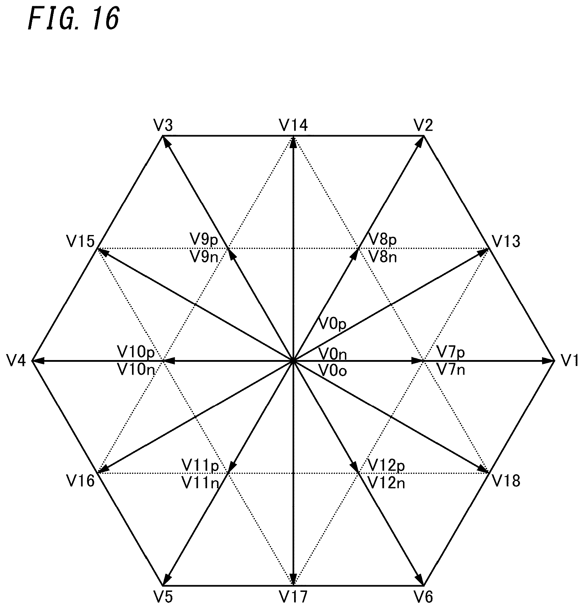

As shown in FIG. 16, one group of voltage vectors includes three zero vectors V0p, V0n, V0o, each of which has a magnitude of zero. In addition, one group of voltage vectors further includes six voltage vectors V1, V2, V3, V4, V5, V6, each of which has a magnitude of $(2/3)^{1/2} \cdot 2Vdc$ and which have mutually different directions. Furthermore, one group of voltage vectors further includes twelve voltage vectors V7p, V7n, V8p, V8n, V9p, V9n, V10p, V10n, V11p, V11n, V12p, V12n, each of which has a magnitude of $(2/3)^{1/2} \cdot Vdc$. Besides, one group of voltage vectors further includes six voltage vectors V13, V14, V15, V16, V17, V18, each of which has a magnitude of $(2/3)^{1/2} \cdot 3^{1/2} \cdot Vdc$ and which have mutually different directions. In FIG. 16, the angle formed between each pair of adjacent voltage vectors belonging to the six voltage vectors V1, V2, V3, V4, V5, V6 is 60 degrees. Likewise, the angle formed between each pair of adjacent voltage vectors belonging to the six voltage vectors V13, V14, V15, V16, V17, V18 is also 60 degrees. Note that FIG. 16 is a vector diagram in which the one group of voltage vectors are plotted on an orthogonal d-q coordinate system.

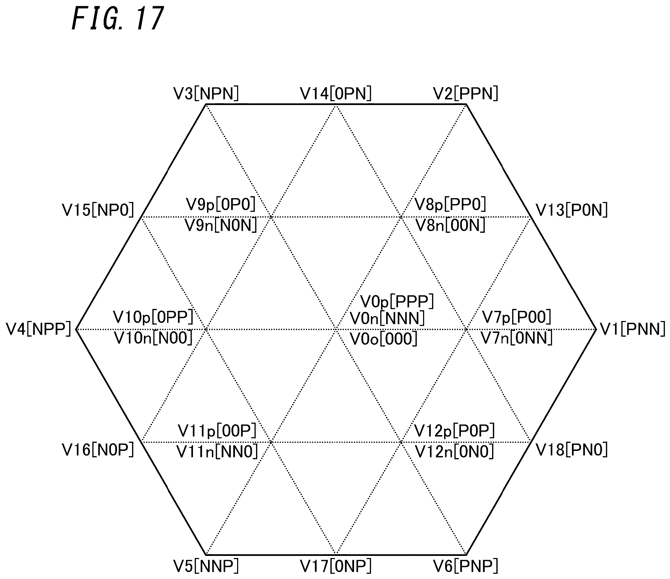

Each group of voltage vectors may be expressed as shown in FIG. 17 if their first, second, and third switching states are designated by the reference signs "P," "0," and "N," respectively, and the respective switching states of the three phases are arranged in the order of U-, V-, and W-phases.

As shown in FIG. 17, the three zero vectors V0p, V0n, V0o may be expressed as V0p[PPP], V0n[NNN], V0o[000], respectively. For example, V0p[PPP] indicates that regarding the zero vector V0p, the switching state of the U-phase switching circuit 10U is "P," the switching state of the V-phase switching circuit 10V is "P," and the switching state of the W-phase switching circuit 10W is "P." A voltage vector with the suffix "p" such as V10p includes "P" but does not include "N." The same statement will apply to the rest of the description. A voltage vector with the suffix "n" such as V10n includes "N" but does not include "P." The same statement will apply to the rest of the description. A voltage vector with the suffix "o" such as V0o includes "0" but includes neither "P" nor "N." If the switching state of a switching circuit 10 is "P," then the potential at the third connection node 13 of the switching circuit 10 will be the potential at the positive electrode P1 of the DC power supply unit 3. If the switching state of a switching circuit 10 is "N," then the potential at the third connection node 13 of the switching circuit 10 will be the potential at the negative electrode N1 of the DC power supply unit 3. If the switching state of a switching circuit 10 is "0," then the potential at the third connection node 13 of the switching circuit 10 will be the potential at the intermediate potential node M1 of the DC power supply unit 3.

The six voltage vectors V1, V2, V3, V4, V5, and V6 may be expressed as V1 [PNN], V2[PPN], V3[NPN], V4[NPP], V5[NNP], and V6[PNP], respectively. A voltage vector with none of the suffixes "p," "n," and "o" added to the numeral following "V" such as V1[PNN], V2[PPN], V3[NPN], V4[NPP], V5[NNP], and V6[PNP] includes "P" and "N" as two out of the three-phase switching states.

The twelve voltage vectors V7p, V7n, V8p, V8n, V9p, V9n, V10p, V10n, V11p, V11n, V12p, and V12n may be expressed as V7p[P00], V7n[0NN], V8p[PP0], V8n[00N], V9p[0P0], V9n[N0N], V10p[0PP], V10n[N00], V11p[00P], V11n [NN0], V12p[P0P], and V12n[0N0], respectively.

The six voltage vectors V13, V14, V15, V16, V17, and V18 may be expressed as V13[P0N], V14[0PN], V15[NP0], V16[N0P], V17[0NP], and V18[PN0], respectively.

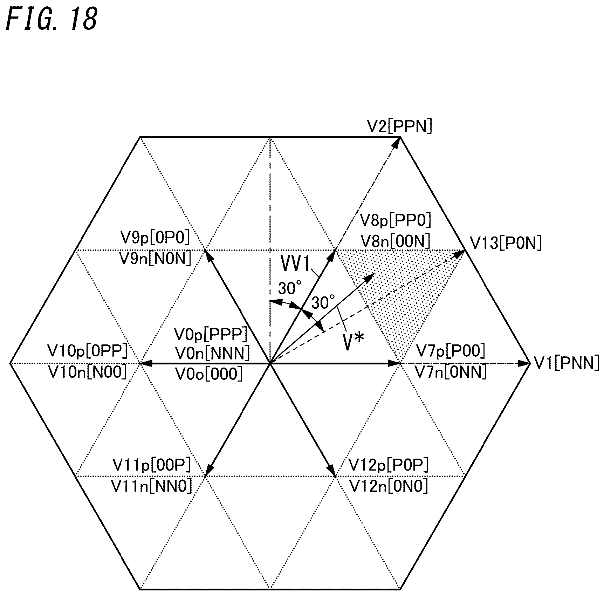

The control unit 60 transforms the instantaneous value of the command voltage with respect to the output voltage of each of the plurality of inverter circuits 1 into a command voltage vector V* (refer to FIG. 18). If the d-axis component of the command voltage vector V* on the orthogonal d-q coordinate system is Vd and the q-axis component of the command voltage vector V* on the orthogonal d-q coordinate system is Vq, then the command voltage vector V* may be given by the following Equation (1):

[Mathematical Expression 1]

$$V^* = \begin{bmatrix} Vd \\ Vq \end{bmatrix} = \sqrt{\frac{2}{3}} \cdot \begin{bmatrix} 1 & -\frac{1}{2} & -\frac{1}{2} \\ 0 & \frac{\sqrt{3}}{2} & -\frac{\sqrt{3}}{2} \end{bmatrix} \begin{bmatrix} Vu \\ Vv \\ Vw \end{bmatrix} \qquad \text{Equation (1)}$$

The control unit 60 selects a plurality of (e.g., five) voltage vectors located adjacent to the command voltage vector V* which belong to the group of voltage vectors. In the example shown in FIG. 18, the plurality of voltage vectors are V8p[PP0], V8n[00N], V13[P0N], V7p[P00], and V7n[0NN].

The angle formed between the voltage vector (hereinafter referred to as a "voltage vector VV1") located closest to the command voltage vector V* and the command voltage vector V* is smaller than 30 degrees.

The control unit 60 makes a synthetic vector of three vectors at the three vertices of an equilateral triangle surrounding the command voltage vector V* equal to the command voltage vector V* within a predetermined control cycle Ts. Specifically, the control unit 60 makes a synthetic vector of the voltage vectors VV1 (e.g., the voltage vector V8p[PP0] and the voltage vector V8n[00N] in the example shown in FIG. 18), the voltage vector V13[P0N], and the voltage vector V7p [P00] and the voltage vector V7n[0NN] equal to the command voltage vector V*. The control cycle Ts is one cycle of a carrier signal. In the control unit 60, in two voltage vectors arranged in line along the time series, the switching state of only one phase out of the U-, V-, and W-phases changes either between "P" and "0" or between "0" and "N" and the same voltage vector is output twice apiece within the control cycle Ts. Suppose the time assigned out of the control cycle Ts to the voltage vector V8p and V8n is T0, the time assigned to the voltage vector V13 is T1, and the time assigned to the voltage vectors V7p and V7n is T2. As for T0, T1, and T2, supposing the voltage vectors at the three vertices of an equilateral triangle surrounding the command voltage vector V* are Va, Vb, and Vc, respectively, the magnitude of the command voltage vector V* is V, and the angle is 0, T0, T1, and T2 are determined to satisfy the following Equations (2) and (3). In Equation (2), "j" represents an imaginary unit. Note that in the example shown in FIG. 18, the voltage vector Va may be, for example, the voltage vector V8p[PP0] and the voltage vector V8n[00N], the voltage vector Vb may be the voltage vector V13 [P0N], and the voltage vectors Vc may be the voltage vector V7p[P00] and the voltage vector V7n[0NN].

[Mathematical Expression 2]

$$V a \cdot T 0 + V b \cdot T 1 + V c \cdot T 2$$
$$= V \cdot T s \cdot \cos \theta + j \, V \cdot T s \cdot \sin \theta$$

Equation (2)

[Mathematical Expression 3]

$$T 0 + T 1 + T 2 = T s$$

Equation (3)

(3) Advantages

In the power converter 100 according to the exemplary embodiment, if the polarity of a current I1 flowing through the output terminal 41 is positive, the control unit 60 makes a transition to the first control mode via the second control mode immediately after having gone through the third control mode.

This configuration may reduce the chances of causing voltage drops in the plurality of first bootstrap circuits 71, the plurality of second bootstrap circuits 72, and the plurality of third bootstrap circuits 73.

Meanwhile, if the control unit 60 made a transition to the first control mode immediately after having gone through the third control mode without going through the second control mode, then the voltage VQ3 across the third switching element Q3 would be greater than the voltage VQ4 across the fourth switching element Q4, thus possibly causing dielectric breakdown to the third switching element Q3. More specifically, in that case, when the transition is made to the first control mode, Vdc/2 would be divided by the third switching element Q3 and the fourth switching element Q4 with the voltage applied to the third switching element Q3 in the third control mode maintained. One of the factors that make the voltage VQ3 across the third switching element Q3 greater than the voltage VQ4 across the fourth switching element Q4 would be making the transition to the first control mode with the electric charges which have been stored in the parasitic capacitor of a MOSFET serving as the third switching element Q3 in the third control mode left stored there without being transferred.

In addition, in the power converter 100 according to the exemplary embodiment, the control unit 60 makes, in the third control mode, the length T4 of an ON period of the fourth switching element Q4 equal to or greater than 90% and equal to or less than 110% of a CR time constant of the third bootstrap circuit 73 for supplying the voltage to the third gate driver 63.

This configuration may contribute to reducing the size of the third gate drivers 63.

Furthermore, in the power converter 100 according to the exemplary embodiment, the DC-DC converter 91 included in the power supply unit 9 supplies voltage to the plurality of fourth gate drivers 64 and the plurality of third bootstrap circuits 73. Thus, the power converter 100 according to the exemplary embodiment may reduce the chances of causing a voltage drop in each of the plurality of third bootstrap circuit 73 while contributing to downsizing.

(Variations)

Note that the embodiment described above is only an exemplary one of various embodiments of the present disclosure and should not be construed as limiting. Rather, the exemplary embodiment may be readily modified in various manners depending on a design choice or any other factor without departing from the scope of the present disclosure.

For example, the plurality of first switching elements Q1, the plurality of second switching elements Q2, the plurality of third switching elements Q3, and the plurality of fourth switching elements Q4 do not have to be MOSFETs but may also be insulated gate bipolar transistors (IGBTs). In that case, in each of the plurality of first switching elements Q1, the plurality of second switching elements Q2, the plurality of third switching elements Q3, and the plurality of fourth switching elements Q4, the control terminal, first main terminal, and second main terminal thereof are a gate terminal, a collector terminal, and an emitter terminal, respectively.

The control unit 60 does not have to be configured to perform the voltage vector control but may also be configured to perform PWM control.

Each of the plurality of first bootstrap circuits 71 includes the Zener diode Z17 in the embodiments described above but may also have a configuration including no Zener diodes Z17. Likewise, each of the plurality of second bootstrap circuits 72 includes the Zener diode Z27 in the embodiments described above but may also have a configuration including no Zener diodes Z27. Likewise, each of the plurality of third bootstrap circuits 73 includes the Zener diode Z37 in the embodiments described above but may also have a configuration including no Zener diodes Z37.

Furthermore, each of the plurality of first bootstrap circuits 71 includes the resistor R17 and is configured to have its CR time constant determined by the capacitance of the capacitor C17 and the resistance value of the resistor R17 in the exemplary embodiment described above. Alternatively, each of the plurality of first bootstrap circuits 71 may include no resistors R17 and may be configured to have its CR time constant determined by the capacitance of the capacitor C17 and the equivalent series resistance (ESR) of the capacitor C17. Each of the plurality of second bootstrap circuits 72 includes the resistor R27 and is configured to have its CR time constant determined by the capacitance of the capacitor C27 and the resistance value of the resistor R27 in the exemplary embodiment described above. Alternatively, each of the plurality of second bootstrap circuits 72 may include no resistors R27 and may be configured to have its CR time constant determined by the capacitance of the capacitor C27 and the ESR of the capacitor C27. Each of the plurality of third bootstrap circuits 73 includes the resistor R37 and is configured to have its CR time constant determined by the capacitance of the capacitor C37 and the resistance value of the resistor R37 in the exemplary embodiment described above. Alternatively, each of the plurality of third bootstrap circuits 73 may include no resistors R37 and may be configured to have its CR time constant determined by the capacitance of the capacitor C37 and the ESR of the capacitor C37.

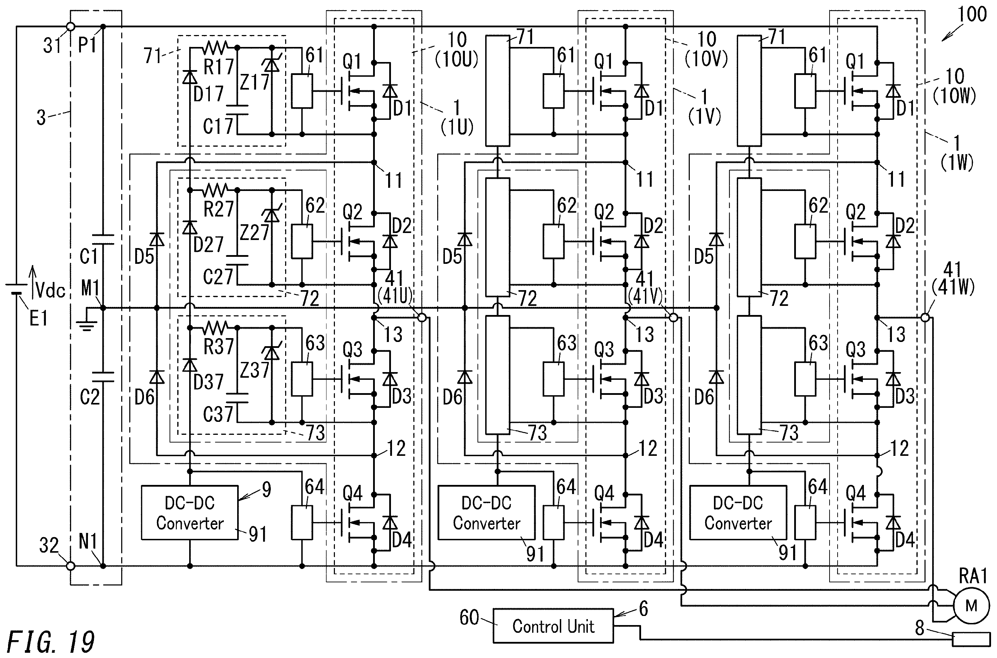

In the embodiment described above, the power converter 100 includes only one DC-DC converter 91 as shown in FIG. 1 as the power supply unit 9 for supplying voltage to the three fourth gate drivers 64. Alternatively, as in the power converter 100 according to a variation shown in FIG. 19, the power supply unit 9 may include a plurality of (e.g., three) DC-DC converters 91. The plurality of DC-DC converters 91 are provided one to one for the plurality of (e.g., three) fourth gate drivers 64. Each of the plurality of DC-DC converters 91 supplies voltage to a corresponding one of the fourth gate drivers 64. In the case of the power converter 100 according to the variation, in each of the plurality of first bootstrap circuits 71, the anode of the diode D17 is connected to the positive-side terminal of a corresponding one of the plurality of DC-DC converters 91. Also, in each of the plurality of second bootstrap circuits 72, the anode of the diode D27 is connected to the positive-side terminal of a corresponding one of the plurality of DC-DC converters 91. Furthermore, in each of the plurality of third bootstrap circuits 73, the anode of the diode D37 is connected to the positive-side terminal of a corresponding one of the plurality of DC-DC converters 91.

Optionally, the power converter 100 may include a plurality of DC-DC converters in place of the plurality of first bootstrap circuits 71, respectively. The power converter 100 may include a plurality of DC-DC converters in place of the plurality of second bootstrap circuits 72, respectively.

Furthermore, the power converter 100 does not have to include the plurality of switching circuits 10 but may also include only one switching circuit 10. If the power converter 100 includes only one switching circuit 10 instead of the plurality of switching circuits 10, then the power converter 100 includes one first gate driver 61, one second gate driver 62, one third gate driver 63, and one fourth gate driver 64 and includes one first bootstrap circuit 71, one second bootstrap circuit 72, and one third bootstrap circuit 73. In that case, the power converter 100 may include DC-DC converters in place of the first bootstrap circuit 71 and the second bootstrap circuit 72, respectively.

Also, the power converter 100 only needs to be a power converter with at least three levels and may be, for example, a five-level inverter.

(Aspects)

The foregoing description provides specific implementations for the following aspects of the present disclosure.

A power converter (100) according to a first aspect includes a DC power supply unit (3), a switching circuit (10), a first diode (D5), a second diode (D6), an output terminal (41), a first gate driver (61), a second gate driver (62), a third gate driver (63), a fourth gate driver (64), a bootstrap circuit (third bootstrap circuit 73), a power supply unit (9), and a control unit (60). The DC power supply unit (3) includes a positive electrode (P1), a negative electrode (N1), and an intermediate potential node (M1). The switching circuit (10) includes a first switching element (Q1), a second switching element (Q2), a third switching element (Q3), and a fourth switching element (Q4). In the switching circuit (10), the first switching element (Q1), the second switching element (Q2), the third switching element (Q3), and the fourth switching element (Q4) are connected in series between the positive electrode (P1) and the negative electrode (N1) to be arranged in this order from the positive electrode (P1) toward the negative electrode (N1). The first diode (D5) has a cathode connected to a first connection node (11) between the first switching element (Q1) and the second switching element (Q2) and an anode connected to the intermediate potential node (M1). The second diode (D6) has an anode connected to a second connection node (12) between the third switching element (Q3) and the fourth switching element (Q4) and a cathode connected to the intermediate potential node (M1). The output terminal (41) is connected to a third connection node (13) between the second switching element (Q2) and the third switching element (Q3) and is to be connected to an AC load (RA1). The first gate driver (61) drives the first switching element (Q1). The second gate driver (62) drives the second switching element (Q2). The third gate driver (63) drives the third switching element (Q3). The fourth gate driver (64) drives the fourth switching element (Q4). The bootstrap circuit (third bootstrap circuit 73) supplies voltage to the third gate driver (63). The power supply unit (3) supplies voltage to the bootstrap circuit (third bootstrap circuit 73) and the fourth gate driver (64). The control unit (60) controls the first gate driver (61), the second gate driver (62), the third gate driver (63), and the fourth gate driver (64). The control unit (60) has a first control mode, a second control mode, and a third control mode. In the first control mode, the control unit (60) controls the first switching element (Q1), the second switching element (Q2), the third switching element (Q3), and the fourth switching element (Q4) such that the first switching element (Q1) is ON, the second switching element (Q2) is ON, the third switching element (Q3) is OFF, and the fourth switching element (Q4) is OFF. In the second control mode, the control unit (60) controls the first switching element (Q1), the second switching element (Q2), the third switching element (Q3), and the fourth switching element (Q4) such that the first switching element (Q1) is OFF, the second switching element (Q2) is ON, the third switching element (Q3) is ON, and the fourth switching element (Q4) is OFF. In the third control mode, the control unit (60) controls the first switching element (Q1), the second switching element (Q2), the third switching element (Q3), and the fourth switching element (Q4) such that the first switching element (Q1) is OFF, the second switching element (Q2) is ON, the third switching element (Q3) is OFF, and the fourth switching element (Q4) is ON. When the polarity of a current flowing through the output terminal (41) is positive, the control unit (60) makes a transition to the first control mode via the second control mode immediately after having gone through the third control mode.

This aspect may reduce the chances of causing a voltage drop in the bootstrap circuit (third bootstrap circuit 73).

A power converter (100) according to a second aspect, which may be implemented in conjunction with the first aspect, further includes: another bootstrap circuit (first bootstrap circuit 71) for supplying voltage to the first gate driver (61); and still another bootstrap circuit (second bootstrap circuit 72) for supplying voltage to the second gate driver (62).

This aspect contributes to further reducing the size of the power converter (100).

In a power converter (100) according to a third aspect, which may be implemented in conjunction with the first or second aspect, the control unit (60) makes, in the third control mode, the length (T4) of an ON period of the fourth switching element (Q4) equal to or greater than 90% and equal to or less than 110% of a CR time constant of the bootstrap circuit (third bootstrap circuit 73) for supplying the voltage to the third gate driver (63).

This aspect may prevent the output voltage of the bootstrap circuit (third bootstrap circuit 73) for supplying the voltage to the third gate driver (63) from decreasing to a predetermined value or less.

In a power converter (100) according to a fourth aspect, which may be implemented in conjunction with any one of the first to third aspects, the bootstrap circuit (third bootstrap circuit 73) for supplying the voltage to the third gate driver (63) includes: a capacitor (C37); and a diode (D37) connected to the capacitor (C37) in series.

In a power converter (100) according to a fifth aspect, which may be implemented in conjunction with the fourth aspect, the bootstrap circuit (third bootstrap circuit 73) for supplying the voltage to the third gate driver (63) further includes a resistor (R37) connected to the capacitor (C37) in series.

In a power converter (100) according to a sixth aspect, which may be implemented in conjunction with any one of the first to fifth aspects, the power supply unit (9) includes a DC-DC converter (91).

A power converter (100) according to a seventh aspect, which may be implemented in conjunction with the first aspect, includes a plurality of the switching circuits (10), a plurality of the first gate drivers (61), a plurality of the second gate drivers (62), a plurality of the third gate drivers (63), a plurality of the fourth gate drivers (64), and a plurality of the bootstrap circuits (third bootstrap circuits 73). The power supply unit (9) supplies voltage to at least the plurality of the fourth gate drivers (64) and the plurality of the bootstrap circuits (third bootstrap circuits 73).

This aspect may reduce the chances of causing a voltage drop in each of the plurality of bootstrap circuits (third bootstrap circuits 73) while contributing to downsizing.

**Reference Signs List**

1 Inverter Circuit
3 DC Power Supply Unit
6 Controller
60 Control Unit
61 First Gate Driver
62 Second Gate Driver
63 Third Gate Driver
64 Fourth Gate Driver
9 Power Supply Unit
91 DC-DC Converter
10 Switching Circuit
11 First Connection Node
12 Second Connection Node
13 Third Connection Node
41 Output Terminal
71 First Bootstrap Circuit
72 Second Bootstrap Circuit
73 Third Bootstrap Circuit

100 Power Converter
C17, C27, C37 Capacitor
D1 Diode
D2 Diode
D3 Diode
D4 Diode
D5 First Diode
D6 Second Diode
D17, D27, D37 Diode
P1 Positive Electrode
Q1 First Switching Element
Q2 Second Switching Element
Q3 Third Switching Element
Q4 Fourth Switching Element
M1 Intermediate Potential Node
N1 Negative Electrode
R17, R27, R37 Resistor
V0p, V0n, V0o Zero Vector
V1-V6 Voltage Vector
V7p, V7n, V8p, V8n, V9p, V9n, V10p, V10n, V11p, V11n, V12p, V12n Voltage Vector
V13-V18 Voltage Vector
V* Command Voltage Vector

**Claims**

1.  A power converter comprising:

    a DC power supply unit including a positive electrode, a negative electrode, and an intermediate potential node;
    a switching circuit including a first switching element, a second switching element, a third switching element, and a fourth switching element which are connected in series between the positive electrode and the negative electrode to be arranged in this order from the positive electrode toward the negative electrode;
    a first diode having a cathode connected to a first connection node between the first switching element and the second switching element and an anode connected to the intermediate potential node;
    a second diode having an anode connected to a second connection node between the third switching element and the fourth switching element and a cathode connected to the intermediate potential node;
    an output terminal connected to a third connection node between the second switching element and the third switching element and configured to be connected to an AC load;
    a first gate driver configured to drive the first switching element;
    a second gate driver configured to drive the second switching element;
    a third gate driver configured to drive the third switching element;
    a fourth gate driver configured to drive the fourth switching element;
    a bootstrap circuit configured to supply voltage to the third gate driver;
    a power supply unit configured to supply voltage to the bootstrap circuit and the fourth gate driver; and
    a control unit configured to control the first gate driver, the second gate driver, the third gate driver, and the fourth gate driver,
    the control unit having:

        a first control mode in which the control unit is configured to control the first switching element, the second switching element, the third switching element, and the fourth switching element such that the first switching element is ON, the second switching element is ON, the third switching element is OFF, and the fourth switching element is OFF;
        a second control mode in which the control unit is configured to control the first switching element, the second switching element, the third switching element, and the fourth switching element such that the first switching element is OFF, the second switching element is ON, the third switching element is ON, and the fourth switching element is OFF; and
        a third control mode in which the control unit is configured to control the first switching element, the second switching element, the third switching element, and the fourth switching element such that the first switching element is OFF, the second switching element is ON, the third switching element is OFF, and the fourth switching element is ON, and

the control unit being configured to, when polarity of a current flowing through the output terminal is positive, make a transition to the first control mode via the second control mode immediately after having gone through the third control mode.

2. The power converter of claim 1, further comprising:

another bootstrap circuit configured to supply voltage to the first gate driver; and
still another bootstrap circuit configured to supply voltage to the second gate driver.

3. The power converter of claim 1 or 2, wherein
the control unit is configured to make, in the third control mode, length of an ON period of the fourth switching element equal to or greater than 90% and equal to or less than 110% of a CR time constant of the bootstrap circuit configured to supply the voltage to the third gate driver.

4. The power converter of any one of claims 1 to 3, wherein
the bootstrap circuit configured to supply the voltage to the third gate driver includes:

a capacitor; and
a diode connected to the capacitor in series.

5. The power converter of claim 4, wherein
the bootstrap circuit configured to supply the voltage to the third gate driver further includes a resistor connected to the capacitor in series.

6. The power converter of any one of claims 1 to 5, wherein
the power supply unit includes a DC-DC converter.

7. The power converter of claim 1, comprising:

a plurality of the switching circuits;
a plurality of the first gate drivers;
a plurality of the second gate drivers;
a plurality of the third gate drivers;
a plurality of the fourth gate drivers; and
a plurality of the bootstrap circuits, wherein
the power supply unit is configured to supply voltage to at least the plurality of the fourth gate drivers and the plurality of the bootstrap circuits.

FIG. 1

EP 4 716 086 A1

# FIG. 2

*FIG. 3*

# FIG. 4

FIG. 5

EP 4 716 086 A1

# FIG. 6

*FIG. 7*

## FIG. 8

FIG. 9

EP 4 716 086 A1

FIG. 10

Output Current

0

Time

*FIG. 11*

FIG. 12

EP 4 716 086 A1

FIG. 13

EP 4 716 086 A1

FIG. 14

FIG. 15

FIG. 16

*FIG. 17*

FIG. 18

FIG. 19

## INTERNATIONAL SEARCH REPORT

| International application No. |
|---|
| **PCT/JP2024/015024** |

**A. CLASSIFICATION OF SUBJECT MATTER**

*H02M 7/48*(2007.01)i; *H02M 1/08*(2006.01)i
FI:  H02M7/48 E; H02M1/08 A

According to International Patent Classification (IPC) or to both national classification and IPC

**B. FIELDS SEARCHED**

Minimum documentation searched (classification system followed by classification symbols)

H02M7/48; H02M1/08

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2013-236544 A (SHARP KABUSHIKI KAISHA) 21 November 2013 (2013-11-21) paragraphs [0087]-[0098], fig. 6 | 1-7 |
| P, A | WO 2024/053452 A1 (PANASONIC INTELLECTUAL PROPERTY MANAGEMENT CO., LTD.) 14 March 2024 (2024-03-14) paragraphs [0013]-[0238], fig. 1-54 | 1-7 |
| P, A | WO 2024/053453 A1 (PANASONIC INTELLECTUAL PROPERTY MANAGEMENT CO., LTD.) 14 March 2024 (2024-03-14) paragraphs [0011]-[0226], fig. 1-46 | 1-7 |

☐ Further documents are listed in the continuation of Box C.      ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **09 May 2024** | **21 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/015024**

| Patent document cited in search report | | | Publication date (day/month/year) | Patent family member(s) | Publication date (day/month/year) |
|---|---|---|---|---|---|
| JP | 2013-236544 | A | 21 November 2013 | US 2013/0083580 A1 paragraphs [0098]-[0109], fig. 6 CN 103036466 A KR 10-2013-0035923 A | |
| WO | 2024/053452 | A1 | 14 March 2024 | (Family: none) | |
| WO | 2024/053453 | A1 | 14 March 2024 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018133876 A